# EUROPEAN PATENT APPLICATION

(11) **EP 4 832 718 A1**
(43) Date of publication of application: **28.10.2026**
(21) Application number: 25870145.7
(22) Date of filing: 09.06.2025
(51) Int. Cl.: H10K 59/126

(54) **DISPLAY PANEL AND DISPLAY DEVICE**

(30) Priority: 27.09.2024 CN 202411369865
(71) Applicant: Hubei Yangtze Industrial Innovation Center of Advanced Display Co., Ltd., East Lake Hi-tech Development Zone Wuhan, Hubei 430074 (CN)
(72) Inventor: HU, Liang, Wuhan, Hubei 430074 (CN)
(74) Representative: Germain Maureau
(86) International application number: PCT/CN2025/099898
(87) International publication number: WO 2026/066233

(57) **Abstract**

Embodiments of the present application relate to the technical field of display, and provide a display panel and a display device, for use in improving the wide-angle anti-peeping effect of the display panel. The display panel comprises: a substrate; a plurality of light-emitting elements located on one side of the substrate, wherein each of the light-emitting elements comprises a first light-emitting unit and a second light-emitting unit; a first light blocking layer located on the side of the first light-emitting unit distant from the substrate, wherein the first light blocking layer comprises a first opening; and a second light blocking layer located on the side of the first light blocking layer distant from the substrate, wherein the second light blocking layer comprises a second opening. In a direction perpendicular to the plane where the substrate is located, both the first opening and the second opening at least partially overlap the first light-emitting unit; and the area of the first opening is greater than that of the second opening, and the orthographic projection of the second light blocking layer on the plane where the substrate is located at least partially covers the edge of the first opening.

## Description

The present application claims priority to Chinese Application No. 202411369865.5 with the application title of "DISPLAY PANEL AND DISPLAY APPARATUS", filed on September 27, 2024, the content of which is incorporated herein by reference in its entirety.

### TECHNICAL FIELD

The present disclosure relates to the field of display technologies, and specifically involves a display panel and a display apparatus.

### BACKGROUND

With the continuous development of display technologies, consumers' requirements for display screens are constantly increasing. At present, various types of display screens, including liquid crystal display screens and organic light-emitting display screens, have emerged in an endless stream and achieved rapid development. On this ground, display technologies such as 3D display, touch display, curved display, ultra-high resolution display and privacy display have been constantly emerging.

Currently, the improvement of the privacy performance of active light-emitting display screens, including organic light-emitting elements (OLED), has attracted great attention from researchers.

### SUMMARY

In view of this, a display panel and a display apparatus are provided according to the present disclosure, to improve the privacy performance at large viewing angles.

In a first aspect, embodiments of the present disclosure provide a display panel. The display panel includes: a substrate; multiple light-emitting elements located on a side of the substrate, the light-emitting element including a first light-emitting unit and a second light-emitting unit; a first light-blocking layer located on a side of the first light-emitting unit away from the substrate and including a first opening; a second light-blocking layer located on a side of the first light-blocking layer away from the substrate and including a second opening. Along a direction perpendicular to a plane of the substrate, both the first opening and the second opening at least partially overlap with the first light-emitting unit. An area of the first opening is greater than an area of the second opening, and an orthographic projection of the second light-blocking layer on the plane of the substrate at least partially covers an edge of the first opening.

In a second aspect, the embodiments of the present disclosure provide a display apparatus including the above-described display panel.

With the solution according to the embodiments of the present disclosure, by providing the first light-emitting unit and the second light-emitting unit that are illuminated in a time-division manner, in conjunction with the arrangement of the first light-blocking layer and the second light-blocking layer, when the first light-emitting unit is turned on, viewers at large viewing angles can be prevented from clearly seeing the displayed image, thereby providing the display panel with a wide-angle privacy effect. When the second light-emitting unit is illuminated, viewers at multiple different viewing angles are all able to see the displayed image, thereby providing the display panel with a sharing effect. Based on this configuration, while enabling the display panel to achieve a wide-angle privacy effect, there is no need to dispose a privacy film on the light-emitting side of the display panel, thereby simplifying the structure of the display panel. Furthermore, in the embodiments of the present disclosure, by controlling the first light-emitting unit and the second light-emitting unit to be illuminated in a time-division manner, convenient switching of the display panel between privacy mode and sharing mode can be realized.

Furthermore, in the embodiments of the present disclosure, by arranging the first light-blocking layer and the second light-blocking layer, configuring the area of the first opening to be greater than the area of the second opening, and configuring the orthographic projection of the second light-blocking layer on the plane where the substrate is located to at least partially cover the edge of the first opening, the first light-blocking layer and the second light-blocking layer together restrict the viewing angle of the display panel. Compared with the solution of disposing only a single light-blocking layer, this configuration achieves a wide-angle privacy effect for the display panel while reducing the width of the first light-blocking layer and the second light-blocking layer required for privacy protection, and increasing the range of viewing angles blocked for privacy purposes. In addition, this configuration also increases the range of viewing angles available in the sharing mode, and ensures that the first light-emitting unit and the second light-emitting unit have a relatively large light-emitting area.

### BRIEF DESCRIPTION OF DRAWINGS

In order to more clearly illustrate technical solutions of embodiments of the present disclosure, the accompanying drawings used in the embodiments are briefly described below. The drawings described below are merely a part of the embodiments of the present disclosure. Based on these drawings, those skilled in the art can obtain other drawings.
FIG. 1 is a top view of a display panel according to some embodiments of the present disclosure.
FIG. 2 is an enlarged view of the region A1 in FIG. 1 according to some embodiments of the present disclosure.
FIG. 3 is a cross-sectional view along the direction BB' in FIG. 2.
FIG. 4 is a cross-sectional view of a display panel in the related art.
FIG. 5 is a cross-sectional view of another display panel in the related art.
FIG. 6 is a schematic circuit diagram of a pixel driving circuit according to some embodiments of the present disclosure.
FIG. 7 is an operating timing diagram of a pixel driving circuit according to some embodiments of the present disclosure in the privacy mode.
FIG. 8 is an operating timing diagram of a pixel driving circuit according to some embodiments of the present disclosure in the sharing mode.
FIG. 9 is a schematic diagram of an optical path of light emitted by a first light-emitting unit according to some embodiments of the present disclosure.
FIG. 10 is an enlarged top view of a light-emitting element according to some embodiments of the present disclosure.
FIG. 11 is a cross-sectional view along the direction CC' in FIG. 10.
FIG. 12 is an enlarged view of another light-emitting element according to some embodiments of the present disclosure.
FIG. 13 is an enlarged view of a light-emitting element group according to some embodiments of the present disclosure.
FIG. 14 is an enlarged view of another light-emitting element group according to some embodiments of the present disclosure.
FIG. 15 is an enlarged view of another light-emitting element group according to some embodiments of the present disclosure.
FIG. 16 is an enlarged view of another display panel according to some embodiments of the present disclosure.
FIG. 17 is a cross-sectional view along the direction DD' in FIG. 15.
FIG. 18 is an enlarged view of another light-emitting element group according to some embodiments of the present disclosure.
FIG. 19 is an enlarged view of another light-emitting element group according to some embodiments of the present disclosure.
FIG. 20 is an enlarged view of another light-emitting element according to some embodiments of the present disclosure.
FIG. 21 is a cross-sectional view along the direction EE' in FIG. 20.
FIG. 22 is an enlarged view of another light-emitting element according to some embodiments of the present disclosure.
FIG. 23 is a cross-sectional view along the direction FF' in FIG. 22.
FIG. 24 is a cross-sectional view of another display panel according to some embodiments of the present disclosure.
FIG. 25 is an enlarged view of another light-emitting element according to some embodiments of the present disclosure.
FIG. 26 is a cross-sectional view along the direction GG' in FIG. 25.
FIG. 27 is another cross-sectional view along the direction GG' in FIG. 25.
FIG. 28 is another cross-sectional view along the direction GG' in FIG. 25.
FIG. 29 is yet another cross-sectional view along the direction GG' in FIG. 25.
FIG. 30 is a schematic diagram of a display apparatus according to some embodiments of the present disclosure.

### DESCRIPTION OF EMBODIMENTS

In order to better understand technical solutions of the present disclosure, the embodiments of the present disclosure are described in details with reference to the drawings.

It should be clear that the described embodiments are merely part of the embodiments of the present disclosure rather than all of the embodiments. All other embodiments obtained by those skilled in the art without paying creative labor shall fall into the protection scope of the present disclosure.

The terms used in some embodiments of the present disclosure are merely for the purpose of describing specific embodiment, rather than limiting the present disclosure. The terms "a/an", , "the" and "said" in a singular form in the embodiment of the present disclosure and the attached claims are also intended to include plural forms thereof, unless noted otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

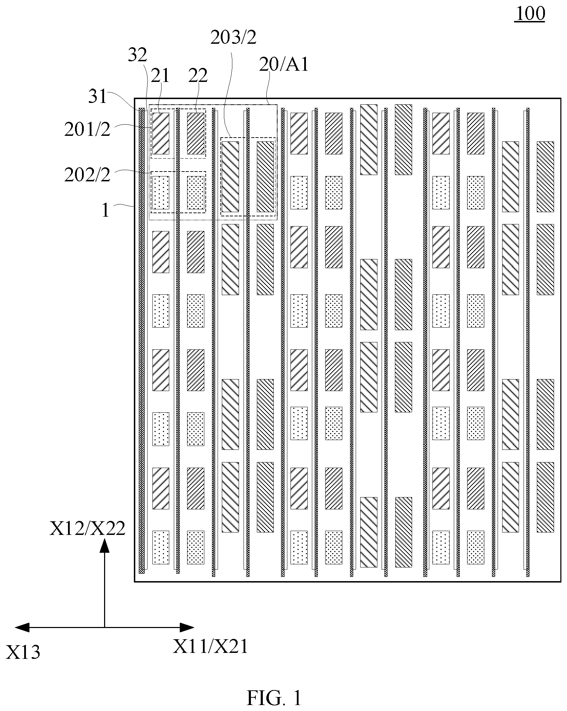

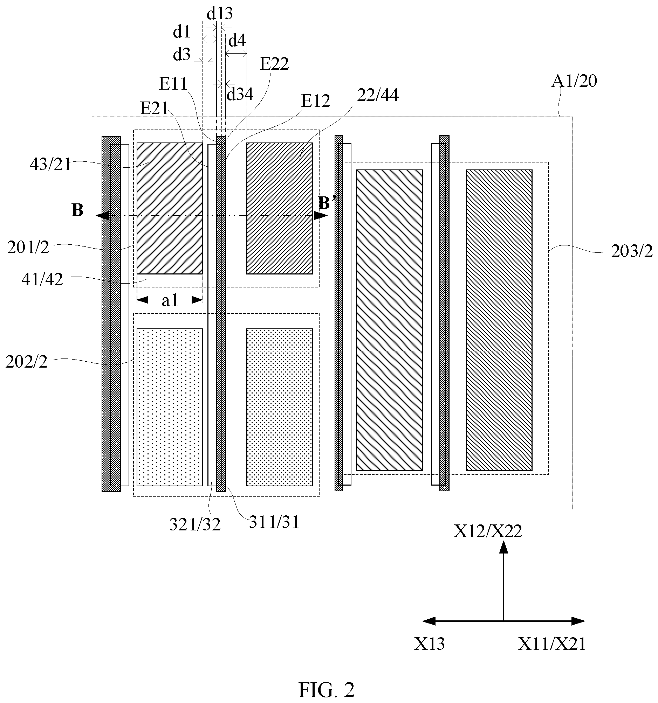

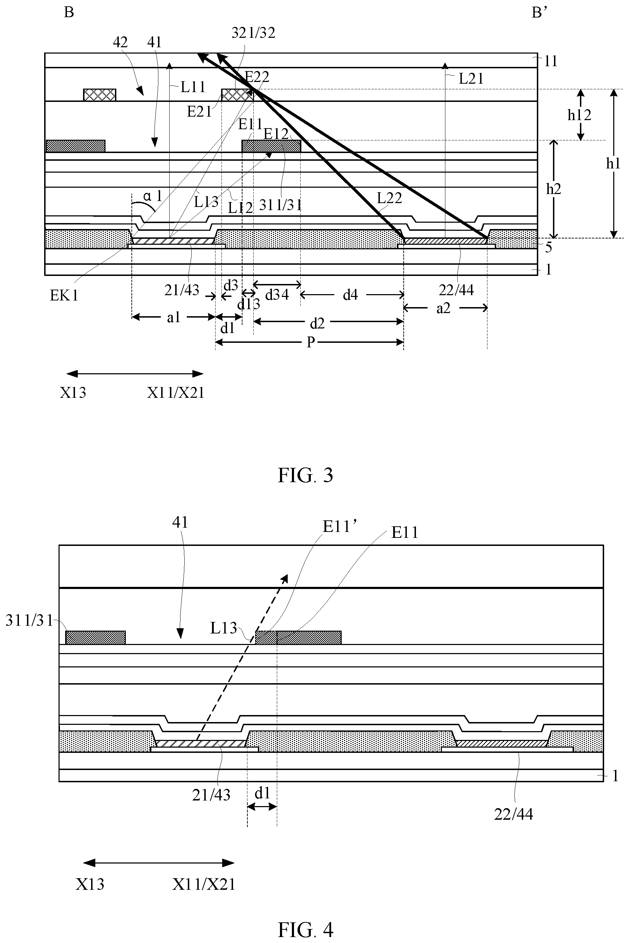

Embodiments of the present disclosure provide a display panel, as shown in FIG. 1. FIG. 1 is a top view of a display panel according to some embodiments of the present disclosure. FIG. 2 is an enlarged view of the region A1 in FIG. 1. FIG. 3 is a cross-sectional view along the direction BB' in FIG. 2. The display panel 100 includes a substrate 1 and a light-emitting element 2. The light-emitting element is located on a side of the substrate 1, and the light-emitting element 2 includes a first light-emitting unit 21 and a second light-emitting unit 22. For example, the light-emitting colors of the first light-emitting unit 21 and the second light-emitting unit 22 may be the same. The first light-emitting unit 21 and the second light-emitting unit 22 may emit light respectively under different operating modes of the display panel.

As shown in FIG. 2 and FIG. 3, the display panel 100 further includes a first light-blocking layer 31 and a second light-blocking layer 32. The first light-blocking layer 31 is located on a side of the first light-emitting unit 21 away from the substrate 1, and the first light-blocking layer 31 includes a first opening 41. The second light-blocking layer 32 is located on a side of the first light-blocking layer 31 away from the substrate 1, and the second light-blocking layer 32 includes a second opening 42. Along the direction perpendicular to the plane of the substrate 1, both the first opening 41 and the second opening 42 at least partially overlap with the first light-emitting unit 21.

For example, as shown in FIG. 2 and FIG. 3, the first light-blocking layer 31 includes a first light-blocking sub-portion 311, and the second light-blocking layer 32 includes a second light-blocking sub-portion 321. Along the first preset direction X11 parallel to the plane of the substrate 1, the first light-blocking sub-portion 311 is located on a side of the first opening 41 away from the first light-emitting unit 21, and the second light-blocking sub-portion 321 is located on a side of the second opening 42 away from the first light-emitting unit 21. Along the direction perpendicular to the plane of the substrate 1, the first light-blocking sub-portion 311 does not overlap with the first light-emitting unit 21, the first light-blocking sub-portion 311 does not overlap with the second light-emitting unit 22, the second light-blocking sub-portion 321 does not overlap with the first light-emitting unit 21, and the second light-blocking sub-portion 321 does not overlap with the second light-emitting unit 22.

The display panel according to the embodiments of the present disclosure may have a large-viewing-angle privacy function. The first preset direction X11 is the direction with privacy requirements. For example, the first preset direction X11 may be a direction towards the left side or right side of the display panel, or the first preset direction X11 may also be a direction towards the upper side or lower side of the display panel. FIG. 1 takes the first preset direction X11 as the direction towards the right side of the display panel for illustration. When the display panel is located on the left side of the viewer and the viewer watches the display image towards the left, it may be understood that the viewer is in the right side of the display panel. When the display panel is located on the right side of the viewer and the viewer watches the display image towards the right, it may be understood that the viewer is in the left side of the display panel. When the display panel is located on the lower side of the viewer and the viewer looks down to watch the display image, it may be understood that the viewer is in the upper side of the display panel. When the display panel is located above the viewer and the viewer looks up to watch the display image, it may be understood that the viewer is in the lower side of the display panel.

For example, the operating modes of the display panel according to the embodiments of the present disclosure include a sharing mode and a privacy mode. The viewing angle of the display panel in the sharing mode is greater than the viewing angle of the display panel in the privacy mode. For example, the maximum viewing angle of the display panel in the privacy mode is 45° (the viewing angle range is 0° - 45°), that is, viewers with a viewing angle greater than 45° cannot clearly see or see the display image. The maximum viewing angle of the display panel in the sharing mode is at least 60° (the corresponding viewing angle range is 0° - 60°). Some display panels require that the maximum viewing angle in the sharing mode is 65° (the viewing angle range is 0° - 65°). It can be appreciated that the maximum viewing angle in the sharing mode may be adjusted according to users' requirements.

In some embodiments, the first light-emitting unit 21 may be used as a privacy pixel that is turned on in the privacy mode, the second light-emitting unit 22 may be used as a sharing pixel that is turned on in the sharing mode. It can be appreciated that both the first light-emitting unit 21 and the second light-emitting unit 22 may be turned on in the sharing mode to increase the brightness of the display panel. For the convenience of explanation, the present disclosure only takes the example that only the second light-emitting unit 22 is turned on in the sharing mode for explanation.

In the privacy mode, the first light-emitting unit 21 is turned on, as shown in FIG. 3. The small-angle light emitted by the first light-emitting unit 21, such as the first light ray L11 shown in FIG. 3, can bypass the first light-blocking sub-portion 311 and the second light-blocking sub-portion 321, and pass through the first opening 41 and the second opening 42 in sequence and exit the display panel 100, so that viewers at a small viewing angle, such as viewers at a front viewing angle, can see the display image. The small-angle light refer to the light rays emitted by the first light-emitting unit 21 with emission angles thereof being smaller than or equal to a first preset angle. The first preset angle may be set according to the requirements of the privacy viewing angles at different viewing sides of the display panel. The emission angle of light is an angle between a propagation direction of the light and the normal of the substrate 1.

In some embodiments, as shown in FIG. 2 and FIG. 3, an area of the first opening 41 is greater than an area of the second opening 42, and an orthographic projection of the second light-blocking layer 32 on the plane of the substrate 1 at least partially covers an edge of the first opening 41.

In the privacy mode, the large-angle light emitted by the first light-emitting unit 21 may be blocked by the first light-blocking sub-portion 311 or the second light-blocking sub-portion 321 and cannot exit the display panel, thus achieving the large-viewing-angle privacy effect of the display panel 100. The large-angle light refer to the light rays emitted by the first light-emitting unit 21 with emission angles thereof being greater than the first preset angle. For example, as shown in FIG. 3, the second light ray L12 emitted by the first light-emitting unit 21 can be blocked by the first light-blocking sub-portion 311 and cannot exit the display panel, and the third light ray L13 can be blocked by the second light-blocking sub-portion 321 and cannot exit the display panel. The emission angle of the third light ray L13 is smaller than the emission angle of the second light ray L12.

In some embodiments of the present disclosure, the second light-emitting unit 22 may be used as a sharing pixel that is turned on in the sharing mode.

In the privacy mode, the second light-emitting unit 22 is turned off.

In the sharing mode, the second light-emitting unit 22 is turned on. The small-angle light emitted by the second light-emitting unit 22, such as the fourth light ray L21 shown in FIG. 3, may exit the display panel. The large-angle light emitted by the second light-emitting unit 22, such as the fifth light ray L22 shown in FIG. 3, can bypass the first light-blocking layer 31 and the second light-blocking layer 32 and exit the display panel, so that viewers at the front viewing angle and large viewing angles can all view the display image, achieving the sharing effect of watching the image by multiple viewers simultaneously.

In the display panel according to the embodiments of the present disclosure, by arranging the first light-emitting unit 21 and the second light-emitting unit 22, and turning on them at different times, in conjunction with the arrangement of the above-described first light-blocking layer 31 and second light-blocking layer 32, viewers at a large viewing angle cannot clearly see the display image when the first light-emitting unit 21 is turned on, that is, the display panel has the large-viewing-angle privacy effect, and viewers at multiple different viewing angles may see the display image when the second light-emitting unit 22 is turned on, that is, the display panel has a sharing effect. Based on this arrangement, there is no need to provide a privacy film on the light-emitting side of the display panel while the display panel has a large-viewing-angle privacy effect, which can reduce the thickness of the display panel and realize the thin and light design of the display panel. Moreover, in some embodiments of the present disclosure, convenient switching between the privacy mode and the sharing mode of the display panel can be achieved by controlling the first light-emitting unit 21 and the second light-emitting unit 22 to be turned on at different times.

Moreover, in some embodiments of the present disclosure, by arranging the first light-blocking layer 31 and the second light-blocking layer 32, and making the area of the first opening 41 greater than the area of the second opening 42 and the orthographic projection of the second light-blocking layer 32 on the plane of the substrate 1 at least partially cover the edge of the first opening 41, the first light-blocking layer 31 and the second light-blocking layer 32 may jointly restrict the viewing angle of the display panel. Compared with the manner of only arranging one light-blocking layer, the width of the first light-blocking layer 31 and the second light-blocking layer 32 required for privacy can be reduced and the range of the privacy viewing angle can be enlarged while achieving the large-viewing-angle privacy effect of the display panel. In addition, the viewing angle range in the sharing mode can also be enlarged.

With combined reference to FIG.3 and FIG. 4, where FIG. 4 is a cross-sectional schematic diagram of a display panel in the related technologies, compared with FIG. 3, the display panel in FIG. 4 only includes the first light-blocking layer 31 with the second light-blocking layer being removed. In FIG. 4, in order to block the third light ray L13 shown in FIG. 3, at least the edge E11' of the first light-blocking sub-portion 311 close to the first light-emitting unit 21 needs to be moved, towards the first light-emitting unit 21, to the position indicated by the dotted line in FIG. 4. As can be seen, this may lead to a reduction in the distance between the edge E11' of the first light-blocking sub-portion 311 and the first light-emitting unit 21 in the first preset direction X11. Even worse, there could be an overlap between the first light-blocking sub-portion 311 and the first light-emitting unit 21 in the direction perpendicular to the plane of the substrate 1, as shown in FIG. 4, which will affect the brightness of the front-view light emitted by the first light-emitting unit 21.

By contrast, in some embodiments of the present disclosure, as shown in FIG. 3, the arrangement of the second light-blocking sub-portion 321 may block a part of the large-angle light emitted by the first light-emitting unit 21, such as the third light ray L13 in FIG.3, which can increase the distance d1 between the first edge E11 of the first light-blocking sub-portion 311 close to the first light-emitting unit 21 and the first light-emitting unit 21 while preventing the third light ray L13 from exiting the display panel 100, so as to prevent the first light-blocking sub-portion 311 from blocking the small-angle light emitted by the first light-emitting unit 21, which is beneficial to improving the brightness of the display panel at the front view in the privacy mode.

In addition, in the case where only the first light-blocking layer 31 is provided without arranging the second light-blocking layer, if the distance between the first edge E11 of the first light-blocking sub-portion 311 and the first light-emitting unit 21 is set as d1 as shown in FIG. 3, the third light ray L13 may exit from the display panel 100 through the first opening 41 as shown in FIG. 4, resulting in that viewers at a large viewing angle of the display panel in the first preset direction X11 may still see the display image, that is, the range of the privacy viewing angle of the display panel in the first preset direction X11 may be reduced, and the privacy effect cannot be well achieved.

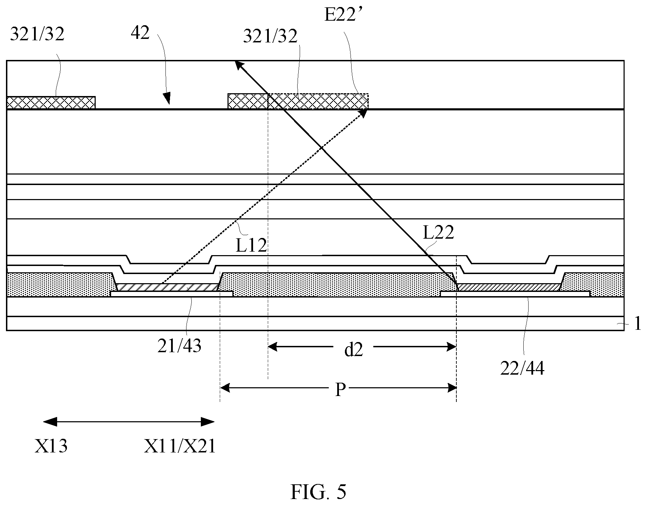

With combined reference to FIG. 3 and FIG. 5, where FIG. 5 is a cross-sectional view of another display panel in the related art, compared with FIG. 3, the display panel in FIG. 5 only includes the second light-blocking layer 32 with the first light-blocking layer being removed. In FIG. 5, in order to block the above-mentioned second light ray L12 with a relatively large emission angle emitted by the first light-emitting unit 21, at least the edge E22' of the second light-blocking sub-portion 321 away from the first light-emitting unit 21 needs to be moved, away from the first light-emitting unit 21, to the position indicated by the dotted line in FIG. 5. In the case where the first light-emitting unit 21 and the second light-emitting unit 22 are arranged along the first preset direction X11 and the spacing P between them is fixed, as shown in FIG. 5, removing the first light-blocking layer may lead to a reduction in the distance between the edge E22' of the second light-blocking sub-portion 321 and the second light-emitting unit 22 in the first preset direction X11, and the fifth light ray L22 emitted by the second light-emitting unit 22, which can originally bypass the second light-blocking sub-portion 321, may be blocked by the second light-blocking sub-portion 321 and cannot exit the display panel.

Based on the arrangement shown in FIG. 5, in order for the fifth light ray L22 emitted by the second light-emitting unit 22 able to bypass the second light-blocking sub-portion 321, it is needed to increase the distance P between the first light-emitting unit 21 and the second light-emitting unit 22 or reduce the area of the second light-emitting unit 22, which may lead to a reduction in the resolution of the display panel or affect the aperture ratio of the second light-emitting unit 22.

By contrast, in some embodiments of the present disclosure, as shown in FIG. 3, the first light-blocking sub-portion 311 can block a part of the large-angle light emitted by the first light-emitting unit 21, such as the second light ray L12 in FIG. 3. In the case where the first light-emitting unit 21 and the second light-emitting unit 22 are arranged along the first preset direction X11, in addition to preventing the second light ray L12 from exiting the display panel, based on the arrangement of the first light-blocking sub-portion 311, the distance between the third edge E22 of the second light-blocking sub-portion 321 and the second light-emitting unit 22 can be increased, preventing the second light-blocking sub-portion 321 from blocking the light rays emitted by the second light-emitting unit 22, which is beneficial to improving the display effect of the display panel in the sharing mode.

In addition, if the distance between the third edge E22 of the second light-blocking sub-portion 321 and the second light-emitting unit 22 is set as d2 as shown in FIG. 3, in the case where only the second light-blocking layer 32 is provided without arranging the first light-blocking layer, as shown in FIG. 5, the second light ray L12 may bypass the second light-blocking sub-portion 321 and exit the display panel 100, resulting in that viewers at a large viewing angle of the display panel can still see the display image, that is, the privacy viewing angle range of the display panel may be reduced, and the privacy effect cannot be well achieved.

From the above, in some embodiments of the present disclosure, by arranging the first light-blocking layer 31 and the second light-blocking layer 32, and making the area of the first opening 41 greater than the area of the second opening 42 and the orthographic projection of the second light-blocking layer 32 on the plane of the substrate 1 at least partially covers the edge of the first opening 41, the first light-blocking layer 31 and the second light-blocking layer 32 can jointly restrict the viewing angle of the display panel. Compared with the manner of only arranging one light-blocking layer, in addition to achieving the large-viewing-angle privacy effect of the display panel 100, the width of the first light-blocking layer 31 and the second light-blocking layer 32 required for privacy can be reduced, and the range of the privacy viewing angle can be enlarged. Moreover, the range of the viewing angle in the sharing mode can also be increased, and it can be ensured that the first light-emitting unit 21 and the second light-emitting unit 22 have relatively large light-emitting areas.

For example, in some embodiments of the present disclosure, the first light-emitting unit 21 and the second light-emitting unit 22 may be driven separately.

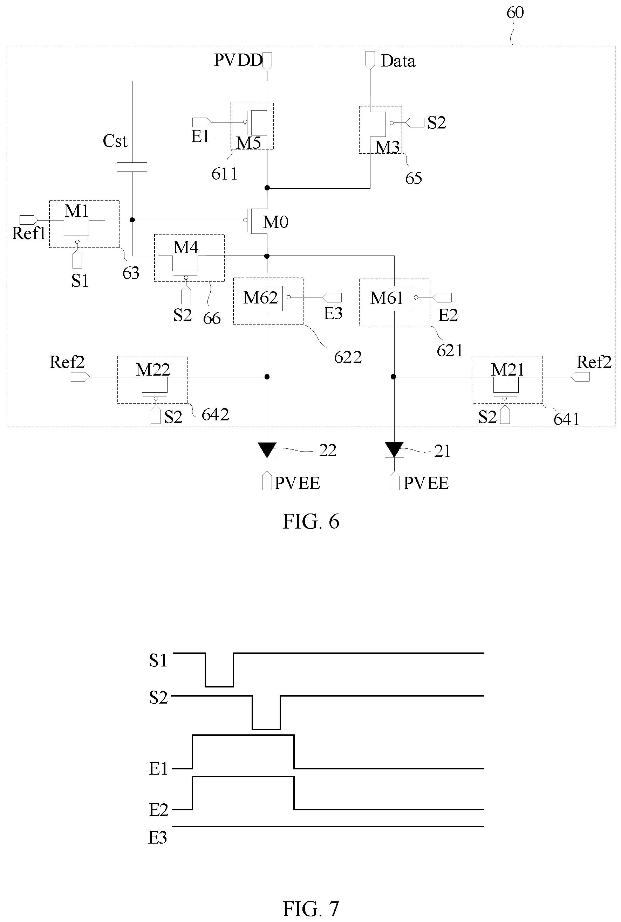

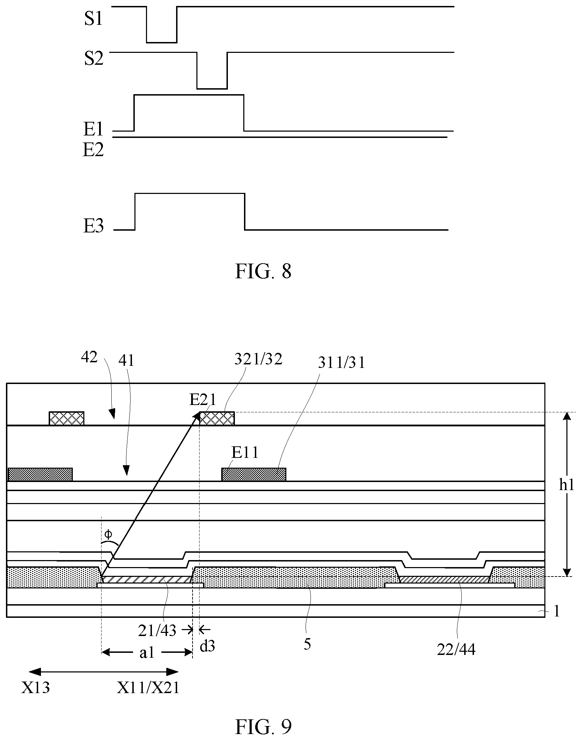

FIG. 6 is a circuit schematic diagram of a pixel driving circuit according to some embodiments of the present disclosure, FIG. 7 is an operating timing diagram of a pixel driving circuit according to some embodiments of the present disclosure in the privacy mode, and FIG. 8 is an operating timing diagram of a pixel driving circuit according to some embodiments of the present disclosure in the sharing mode. The display panel further includes a pixel driving circuit 60. The pixel driving circuit 60 includes a first light-emitting control module 611, a second light-emitting control module 621, a third light-emitting control module 622, a gate reset module 63, a first anode reset module 641, a second anode reset module 642, a data writing module 65, a threshold compensation module 66 and a storage capacitor Cst.

The gate reset module 63 includes a gate reset transistor M1. The gate reset transistor M1 is electrically connected between a first reset signal line Ref1 and a gate of the driving transistor M0, and is configured to reset the gate of the driving transistor M0 in response to the effective level provided by the first scanning signal line S1.

The first anode reset module 641 includes a first anode reset transistor M21. The first anode reset transistor M21 is electrically connected between the second reset signal line Ref2 and the first light-emitting unit 21, and is used to reset the anode voltage of the first light-emitting unit 21 in response to the effective level provided by the second scanning signal line S2.

The second anode reset module 642 includes a second anode reset transistor M22. The second anode reset transistor M22 is electrically connected between the second reset signal line Ref2 and the second light-emitting unit 22, and is configured to reset the anode voltage of the second light-emitting unit 22 in response to the effective level provided by the second scanning signal line S2.

The data writing module 65 includes a data writing transistor M3. The data writing transistor M3 is electrically connected between the data line Data and a first electrode of the driving transistor M0. The threshold compensation module 66 includes a threshold compensation transistor M4. The threshold compensation transistor M4 is electrically connected between a second electrode of the driving transistor M0 and the gate of the driving transistor M0. The data writing transistor M3 and the threshold compensation transistor M4 are configured to write the data voltage into the gate of the driving transistor M0 and perform threshold compensation on the driving transistor M0 in response to the effective level provided by the second scanning signal line S2.

The first light-emitting control module 611 includes a first light-emitting control transistor M5. The first light-emitting control transistor M5 is electrically connected between the power supply signal line PVDD and the first electrode of the driving transistor M0.

The second light-emitting control module 621 includes a second light-emitting control transistor M61. The second light-emitting control transistor M61 is electrically connected between the second electrode of the driving transistor M0 and the first light-emitting unit 21.

The third light-emitting control module 622 includes a third light-emitting control transistor M62. The second light-emitting control transistor M62 is electrically connected between the second electrode of the driving transistor M0 and the second light-emitting unit 22.

For example, in the privacy mode, as shown in FIG. 6 and FIG. 7, the pixel driving circuit 60 transmits, in response to the enable levels provided by the first light-emitting control signal line E1 and the second light-emitting control signal line E2, the driving current converted by the driving transistor M0 to the first light-emitting unit 21 to drive the first light-emitting unit 21 to emit light. In addition, in response to the non-enable level provided by the third light-emitting control signal line E3, the second light-emitting unit 22 is controlled to not emit light.

In the sharing mode, as shown in FIG. 6 and FIG. 8, the pixel driving circuit 60 transmits, in response to the enable levels provided by the first light-emitting control signal line E1 and the third light-emitting control signal line E3, the driving current converted by the driving transistor M0 to the second light-emitting unit 22 to drive the second light-emitting unit 22 to emit light. In addition, in response to the non-enable level provided by the second light-emitting control signal line E2, the transmission path between the pixel driving circuit 60 and the first light-emitting unit 21 is controlled to be turned off, so that the first light-emitting unit 21 does not emit light.

Based on the above structure, the first light-emitting unit 21 and the second light-emitting unit 22 may share the driving current provided by the same pixel driving circuit 60 to emit light, which simplifies the circuit design of the display panel 100 and reduces the occupied space of the pixel driving circuit 60 within the display panel 100, and is beneficial to increasing the pixel density.

Referring to FIG. 6, in order to increase the brightness of the display panel in the sharing mode, both of the first light-emitting unit 21 and the second light-emitting unit 22 may be driven to emit light in the sharing mode. In this case, the first light-emitting control signal line E1, the second light-emitting control signal line E2 and the third light-emitting control signal line E3 all provide enable levels in the light-emitting stage.

It can be understood that FIG. 6 takes the example that the first light-emitting unit 21 and the second light-emitting unit 22 share one pixel driving circuit 60 for illustration. In actual design, the first light-emitting unit 21 and the second light-emitting unit 22 may also be driven by different pixel driving circuits respectively, which will not be elaborated here.

For example, as shown in FIG. 2 and FIG. 3, along the first preset direction X11, the first light-blocking sub-portion 311 includes a first edge E11 close to the first light-emitting unit 21, and the second light-blocking sub-portion 321 includes a second edge E21 close to the first light-emitting unit 21.

As shown in FIG. 3, the display panel further includes a pixel definition layer 5. The pixel definition layer 5 includes a third opening 43 and a fourth opening 44. At least part of the first light-emitting unit 21 is located within the third opening 43, and at least part of the second light-emitting unit 22 is located within the fourth opening 44.

As shown in FIG. 2 and FIG. 3, along the first preset direction X11, the shortest distance between the first edge E11 and the third opening 43 is d1, the shortest distance between the second edge E21 and the third opening 43 is d3. Along the direction perpendicular to the plane of the substrate 1, the shortest distance between the surface of the second light-blocking sub-portion 321 away from the substrate 1 and the surface of the first light-emitting unit 21 away from the substrate 1 is h1. The first light-emitting unit 21 may include a first electrode, a light-emitting layer and a second electrode which are stacked. The surface of the first light-emitting unit 21 away from the substrate 1 may be the surface of the light-emitting layer in the first light-emitting unit 21 away from the substrate 1. As shown in FIG. 2 and FIG. 3, along the first preset direction X11, the length of the third opening 43 is a1.

In some embodiments, d3 + a1 ≤ tan (arcsin (n2 × sinθ/n1) ) × h1, where θ is the maximum viewing angle in the privacy mode. For example, for display panels with different privacy requirements, θ may be 28°, 30° or 45°, n1 is a refractive index of the display panel, and n2 is a refractive index of air. The refractive index of the display panel may be understood as the equivalent refractive index of multiple film layers located on the side of the first light-emitting unit 21 close to the light-emitting side of the display panel. Based on this arrangement, d3 + a1 ≤ tan (arcsin (n2 × sinθ/n1) ) × h1 can be achieved. FIG. 9 is a schematic diagram of an optical path of light emitted by the first light-emitting unit according to some embodiments of the present disclosure. As shown in FIG. 9, tanφ = (d3 + a1)/h1 ≤ tan(arcsin(n2 × sinθ/n1)), that is, φ ≤ arcsin(n2 × sinθ/n1), φ is a maximum emission angle of the light rays emitted by the first light-emitting unit 21 and passing through the second opening 42, that is, the maximum emission angle of the light rays emitted by the first light-emitting unit 21 and passing through the second opening 42 is smaller than or equal to θ, so that the light ray emitted by the first light-emitting unit 21 with an emission angle greater than θ is directed to the second light-blocking sub-portion 321 or the first light-blocking sub-portion 311, so as to be blocked by the second light-blocking sub-portion 321 or the first light-blocking sub-portion 311, meeting the requirement for privacy viewing angle of the display panel in the left and right directions.

In some embodiments, n1 may be 1.42, n2 may be 1, and θ may be 45°. In this case, it may be calculated that: d3 + a1 ≤ tan30° × h1. Based on this arrangement, the emission angle of the light rays emitted by the first light-emitting unit 21 and passing through the second opening 42 may smaller than or equal to 45°.

It should be noted that the above d3 may be a positive value or a negative value. In the case where d3 is a negative value, it indicates that the orthographic projection of the second edge E21 on the plane of the substrate 1 is within the third opening 43.

In some embodiments, d3 ≥ 0. For example, in some embodiments of the present disclosure, d3 = 0, that is, the orthographic projection of the second edge E21 on the plane of the substrate 1 coincides with the edge of the first light-emitting unit 21.

For example, as shown in FIG. 2 and FIG. 3, along the first preset direction X11, the second light-blocking sub-portion 321 includes a third edge E22 away from the first light-emitting unit 21. The shortest distance between the first edge E11 and the third edge E22 is d13. As shown in FIG. 3, along the first preset direction X11, the third opening 43 includes a first opening edge EK1 away from the second light-blocking sub-portion 321. A maximum angle between the line connecting the first opening edge EK1 and the third edge E22 and the normal of the substrate 1 is α1.

Along the direction perpendicular to the plane of the substrate 1, the shortest distance between the surface of the first light-blocking sub-portion 311 away from the substrate 1 and the surface of the second light-blocking sub-portion 321 away from the substrate 1 is h12, as shown in FIG. 3. In some embodiments, d13 ≥ h12 × tanα1. Based on this arrangement, the first light-blocking sub-portion 311 and the second light-blocking sub-portion 321 may absorb more large-angle light emitted by the first light-emitting unit 21, to ensure that the large-angle light emitted by the first light-emitting unit 21 cannot exit from between the first light-blocking sub-portion 311 and the second light-blocking sub-portion 321, which can improve the privacy effect of the display panel in the first preset direction X11.

In some embodiments, as shown in FIG. 1, FIG. 2 and FIG. 3, the first light-emitting unit 21 and the second light-emitting unit 22 may be arranged along the above-described first preset direction X11. As shown in FIG. 2 and FIG. 3, along the first preset direction X11 parallel to the plane of the substrate 1, the first light-blocking sub-portion 311 is located on the side of the first opening 41 close to the second light-emitting unit 22.

As shown in FIG. 2 and FIG. 3, along the first preset direction X11, a minimum distance between the third edge E22 of the second light-blocking sub-portion 321 and the second light-emitting unit 22 is d2, and the shortest distance between the first light-blocking sub-portion 311 and the fourth opening 44 is d4. As shown in FIG. 3, along the direction perpendicular to the plane of the substrate 1, the shortest distance between the surface of the second light-blocking sub-portion 321 away from the substrate 1 and the surface of the first light-emitting unit 21 away from the substrate 1 is h1, and the shortest distance between the surface of the second light-emitting unit 22 away from the substrate 1 and the surface of the first light-blocking sub-portion 311 away from the substrate 1 is h2. The second light-emitting unit 22 may include a first electrode, a light-emitting layer and a second electrode which are stacked. The surface of the second light-emitting unit 22 away from the substrate 1 may be the surface of the light-emitting layer in the second light-emitting unit 22 away from the substrate 1, where d4 ≥ d2 × h2/h1 . Based on this arrangement, d4 ≥ d2 × h2/h1 may be achieved, so that the large-angle light emitted by the second light-emitting unit 22 and directed to the third edge E22 can easily bypass the first light-blocking sub-portion 311, which is beneficial to meeting the brightness requirements of the sharing viewing angle of the display panel in the first preset direction X11.

As shown in FIG. 2 and FIG. 3, the shortest distance between the surface of the second light-emitting unit 22 away from the substrate 1 and the surface of the first light-blocking sub-portion 311 away from the substrate 1 is h2. The second light-emitting unit 22 may include a first electrode, a light-emitting layer and a second electrode which are stacked. The surface of the second light-emitting unit 22 away from the substrate 1 may be the surface of the light-emitting layer in the second light-emitting unit 22 away from the substrate 1. In some embodiments of the present disclosure, a2 + d2 ≥ tan(arcsin(n2 × sinβ/ n1)) × h1, where β is a maximum viewing angle in the sharing mode, and n1 is a refractive index of the display panel, and n2 is a refractive index of air. The refractive index of the display panel may be understood as the equivalent refractive index of multiple film layers located on a side of the second light-emitting unit 22 close to the light-emitting side of the display panel. Based on this arrangement, the emission angle of the light rays emitted by the second light-emitting unit 22 towards the first preset direction X11 and bypassing the second light-blocking sub-portion 321 may be greater than or equal to β, that is, the light rays emitted by the second light-emitting unit 22 towards the first preset direction X11 and with an emission angle greater than β may easily bypass the second light-blocking sub-portion 321, which is beneficial to meeting the sharing viewing angle requirements of the display panel in the first preset direction X11. Moreover, by this arrangement, there is no need to increase the distance between the first light-emitting unit 21 and the second light-emitting unit 22, nor is there a need to reduce the area of the first light-emitting unit 21 or the second light-emitting unit 22, which is beneficial to ensuring that the first light-emitting unit 21 and the second light-emitting unit 22 have relatively large light-emitting areas.

In some embodiments, n1 may be 1.42, n2 may be 1, and β may be 90°. In this case, it may be calculated that: d2 + a2 ≥ tan45° × h1 = h1.

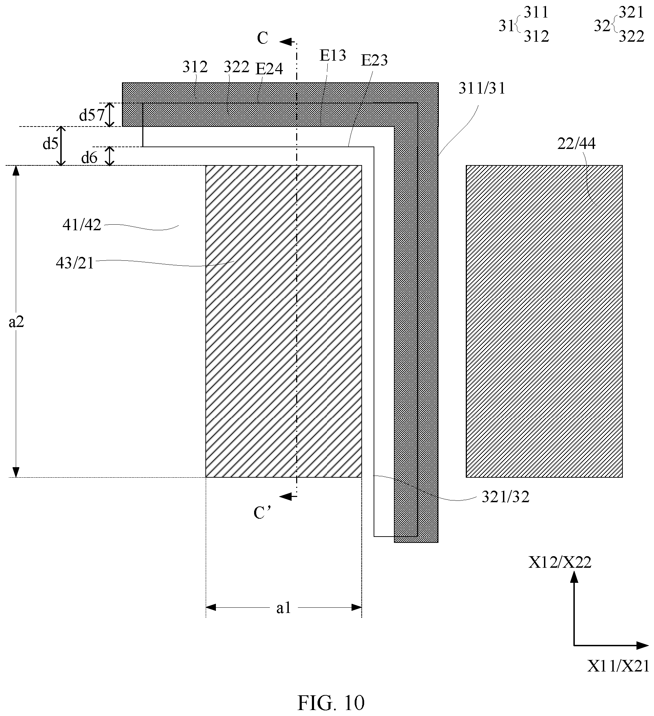

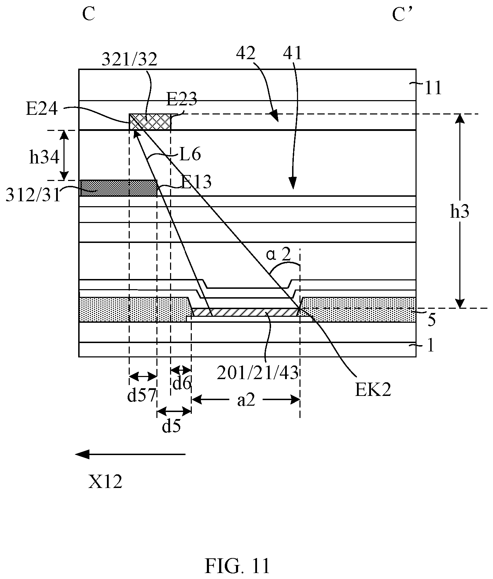

FIG. 10 is an enlarged view of a light-emitting element according to some embodiments of the present disclosure, and FIG. 11 is a cross-sectional view along the direction CC' in FIG. 10. For example, as shown in FIG. 10 and FIG. 11, the first light-blocking layer 31 further includes a third light-blocking sub-portion 312, and the second light-blocking layer 32 further includes a fourth light-blocking sub-portion 322. Along the second preset direction X12 parallel to the plane of the substrate 1, the third light-blocking sub-portion 312 is located on the side of the first opening 41 away from the first light-emitting unit 21, the fourth light-blocking sub-portion 322 is located on the side of the second opening 42 away from the first light-emitting unit 32, and the second preset direction X12 intersects with the first preset direction X11. In FIG. 10, the second preset direction X12 is perpendicular to the first preset direction X11, for example.

As shown in FIG. 10 and FIG. 11, along the second preset direction X12, the third light-blocking sub-portion 312 includes a fifth edge E13 close to the first light-emitting unit 21, and the fourth light-blocking sub-portion 322 includes a sixth edge E23 close to the first light-emitting unit 21. The shortest distance between the fifth edge E13 and the first light-emitting unit 21 is d5, and the shortest distance between the sixth edge E23 and the first light-emitting unit 21 is d6. Along the direction perpendicular to the plane of the substrate 1, the shortest distance between the surface of the fourth light-blocking sub-portion 322 away from the substrate 1 and the surface of the first light-emitting unit 21 away from the substrate 1 is h3. The first light-emitting unit 21 may include a first electrode, a light-emitting layer and a second electrode which are stacked. The surface of the first light-emitting unit 21 away from the substrate 1 may be the surface of the light-emitting layer in the first light-emitting unit 21 away from the substrate 1. Along the second preset direction X12, the length of the third opening 43 is a2.

In some embodiments of the present disclosure, d6 + a2 ≤ tan(arcsin(n2 × sinθ/ n1)) × h3, where θ is the maximum viewing angle in the privacy mode. For example, for display panels with different privacy requirements, θ may be 28°, 30°or 45°. n1 is a refractive index of the display panel , and n2 is an area refractive index. The refractive index of the panel may be understood as the equivalent refractive index of multiple film layers located on the side of the first light-emitting unit 21 close to the light-emitting side of the display panel. Based on this arrangement, the emission angle of the light ray emitted by the first light-emitting unit 21 towards the second preset direction X12 and passing through the second opening 42 can be smaller than or equal to θ, so that the light ray emitted by the first light-emitting unit 21 towards the second preset direction X12 and with an emission angle greater than θ is directed to the fourth light-blocking sub-portion 322 or the third light-blocking sub-portion 312, so as to be blocked by the fourth light-blocking sub-portion 322 or the third light-blocking sub-portion 312, meeting the requirement for privacy viewing angle of the display panel in the vertical direction.

In some embodiments, n1 may be 1.42, n2 may be 1, and θ may be 45°. In this case, it can be calculated that: d6 + a2 ≤ tan30° × h3. Based on this arrangement, the emission angle of the light ray emitted by the first light-emitting unit 21 and passing through the second opening 42 may be smaller than or equal to 45°.

It should be noted that the above d6 may be a positive value, or a negative value. In the case where d6 is a negative value, it indicates that the orthographic projection of the sixth edge E23 on the plane of the substrate 1 is within the third opening 43.

For example, the above-described first preset direction X11 may correspond to a direction towards the left side or right side of the display panel. The second preset direction X12 may correspond to a direction towards the upper side or lower side of the display panel.

In some embodiments, the display panel may be used for a vehicle-mounted display screen. In this case, the first preset direction X11 may be approximately parallel to the arrangement direction of the driver's seat and the passenger's seat. In the privacy mode, the arrangement of the first light-blocking sub-portion 311 and the second light-blocking sub-portion 321 may prevent the display content of the vehicle-mounted display screen located on the passenger's seat from interfering with the driver located on the driver's seat, which is beneficial to improving driving safety. The second preset direction X12 may be the vertical direction of the display panel, and the vertical direction is approximately parallel to the arrangement direction of the vehicle-mounted display screen and the windshield. In the privacy mode, the arrangement of the third light-blocking sub-portion 312 and the fourth light-blocking sub-portion 322 may prevent the display content of the vehicle-mounted display screen located on the passenger's seat from being projected onto the windshield and then reflected by the windshield into the driver's eyes, which is beneficial to improving driving safety.

In some embodiments of the present disclosure, d6 ≥ 0. For example, according to some embodiments of the present disclosure d6 = 0. That is, the orthographic projection of the sixth edge E23 on the plane of the substrate 1 coincides with the edge of the first light-emitting unit 21.

For example, as shown in FIG. 10 and FIG. 11, along the second preset direction X12, the fourth light-blocking sub-portion 322 includes a seventh edge E24 away from the first light-emitting unit 21, and the shortest distance between the seventh edge E24 and the fifth edge E13 is d57.

As shown in FIG. 11, along the second preset direction X12, the third opening 43 includes a second opening edge EK2 away from the fifth edge E13, and the maximum angle between the line connecting the second opening edge EK2 and the seventh edge E24 and the normal of the substrate 1 is α2.

Along the direction perpendicular to the plane of the substrate 1, the shortest distance between the surface of the third light-blocking sub-portion 312 away from the substrate 1 and the surface of the fourth light-blocking sub-portion 322 away from the substrate 1 is h34.

In some embodiments of the present disclosure, d57 ≥ h34 × tanα2. Based on this arrangement, the third light-blocking sub-portion 312 and the fourth light-blocking sub-portion 322 may absorb more large-angle light emitted by the first light-emitting unit 21 towards the second preset direction X12, guaranteeing that the large-angle light emitted by the first light-emitting unit 21 towards the second preset direction X12 cannot exit from between the third light-blocking sub-portion 312 and the fourth light-blocking sub-portion 322, which can improve the privacy effect of the display panel in the second preset direction X12.

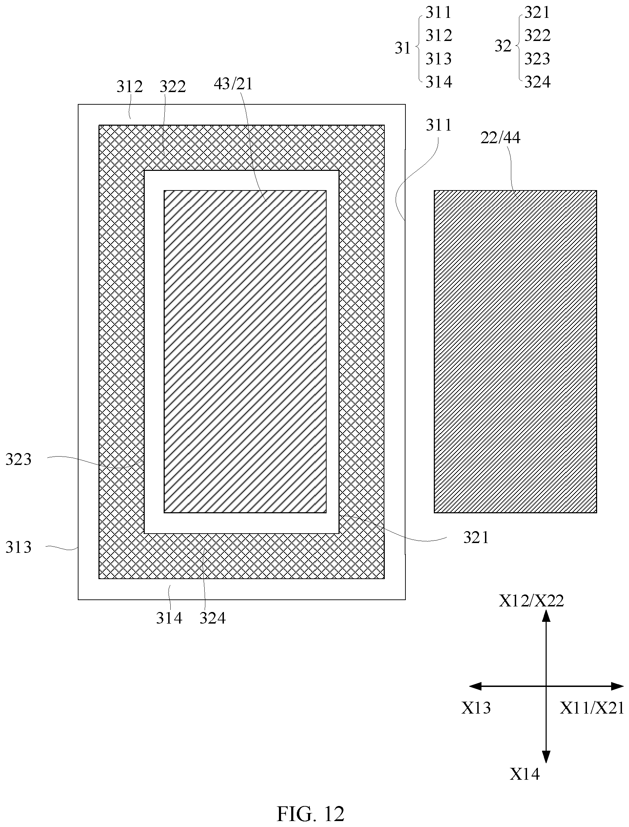

FIG. 12 is an enlarged view of another light-emitting element according to some embodiments of the present disclosure. For example, as shown in FIG. 12, a fifth light-blocking sub-portion 313 and a sixth light-blocking sub-portion 314 may also be arranged in the first light-blocking layer 31, and a seventh light-blocking sub-portion 323 and an eighth light-blocking sub-portion 324 may be arranged in the second light-blocking layer 32. Along the third preset direction X13, the fifth light-blocking sub-portion 313 is located on the side of the first opening 41 away from the first light-emitting unit 21, and the seventh light-blocking sub-portion 323 is located on the side of the second opening 42 away from the first light-emitting unit 21. Along the fourth preset direction X14, the sixth light-blocking sub-portion 314 is located on the side of the first opening 41 away from the first light-emitting unit 21, and the eighth light-blocking sub-portion 324 is located on the side of the second opening 42 away from the first light-emitting unit 21. For example, the third preset direction X13 may be the opposite direction of the first preset direction X11, and the fourth preset direction X14 may be the opposite direction of the second preset direction X12. Based on this arrangement, the first light-blocking sub-portion 311, the third light-blocking sub-portion 312, the fifth light-blocking sub-portion 313 and the sixth light-blocking sub-portion 314 define and surround the above-described first opening 41, and the second light-blocking sub-portion 321, the fourth light-blocking sub-portion 322, the seventh light-blocking sub-portion 323 and the eighth light-blocking sub-portion 324 define and surround the above-described second opening 42, so that the display panel also achieves a large-viewing-angle privacy effect in the third preset direction X13 and the fourth preset direction X14, that is, the display panel can achieve multi-directional privacy.

In some embodiments of the present disclosure, as shown in FIG. 1, the display panel 100 includes multiple light-emitting element groups 20. The light-emitting element group 20 include a first-color light-emitting sub-element 201, a second-color light-emitting sub-element 202 and a third-color light-emitting sub-element 203. In the same light-emitting element group 20, as shown in FIG. 2, the third-color light-emitting sub-element 203 and the first-color light-emitting sub-element 201 are arranged along the first direction X21, the third-color light-emitting sub-element 203 and the second-color light-emitting sub-element 202 are arranged along the first direction X21, and the first-color light-emitting sub-element 201 and the second-color light-emitting sub-element 202 are arranged along the second direction X22, where the first direction X21 intersects with the second direction X22.

In some embodiments of the present disclosure, at least one of the first-color light-emitting sub-element 201, the second-color light-emitting sub-element 202 and the third-color light-emitting sub-element 203 includes the first light-emitting unit 21 and the second light-emitting unit 22.

For example, the first-color light-emitting sub-element 201 includes the first light-emitting unit 21 and the second light-emitting unit 22, or the second-color light-emitting sub-element 202 includes the first light-emitting unit 21 and the second light-emitting unit 22, or the third-color light-emitting sub-element 203 includes the first light-emitting unit 21 and the second light-emitting unit 22, or both the first-color light-emitting sub-element 201 and the second-color light-emitting sub-element 202 include the first light-emitting unit 21 and the second light-emitting unit 22, or both the second-color light-emitting sub-element 202 and the third-color light-emitting sub-element 203 include the first light-emitting unit 21 and the second light-emitting unit 22, or both the first-color light-emitting sub-element 201 and the third-color light-emitting sub-element 203 include the first light-emitting unit 21 and the second light-emitting unit 22. Or all of the first-color light-emitting sub-element 201, the second-color light-emitting sub-element 202 and the third-color light-emitting sub-element 203 include the first light-emitting unit 21 and the second light-emitting unit 22.

In FIG. 1, all of the first-color light-emitting sub-element 201, the second-color light-emitting sub-element 202 and the third-color light-emitting sub-element 203 include the first light-emitting unit 21 and the second light-emitting unit 22, for example.

It should be noted that both the first light-emitting unit 21 and the second light-emitting unit 22 in the first-color light-emitting sub-element 201 emit light of the first color, both the first light-emitting unit 21 and the second light-emitting unit 22 in the second-color light-emitting sub-element 202 emit light of the second color, and both the first light-emitting unit 21 and the second light-emitting unit 22 in the third-color light-emitting sub-element 203 emit light of the third color.

For example, as shown in FIG. 2, the first direction X21 may be parallel to the above-described first preset direction X11, and the second direction X22 may be parallel to the above-described second preset direction X12.

When arranging the above-described first light-emitting unit 21 and second light-emitting unit 22, for example, as shown in FIG. 1, FIG. 2 and FIG. 10, in the same light-emitting element 2, the first light-emitting unit 21 and the second light-emitting unit 22 may be arranged along the first direction X21 according to some embodiments of the present disclosure. In this case, as shown in FIG. 2 and FIG. 10, along the first direction X21, the first light-blocking sub-portion 311 and the second light-blocking sub-portion 312 are located between the first light-emitting unit 21 and the second light-emitting unit 22, and the display panel achieves a privacy effect in the first direction X21. As shown in FIG. 10, along the second direction X22, the third light-blocking sub-portion 312 and the fourth light-blocking sub-portion 322 are respectively located on sides of the first opening 41 and the second opening 42 away from the first light-emitting unit 22, and the display panel achieves a privacy effect in the second direction X22.

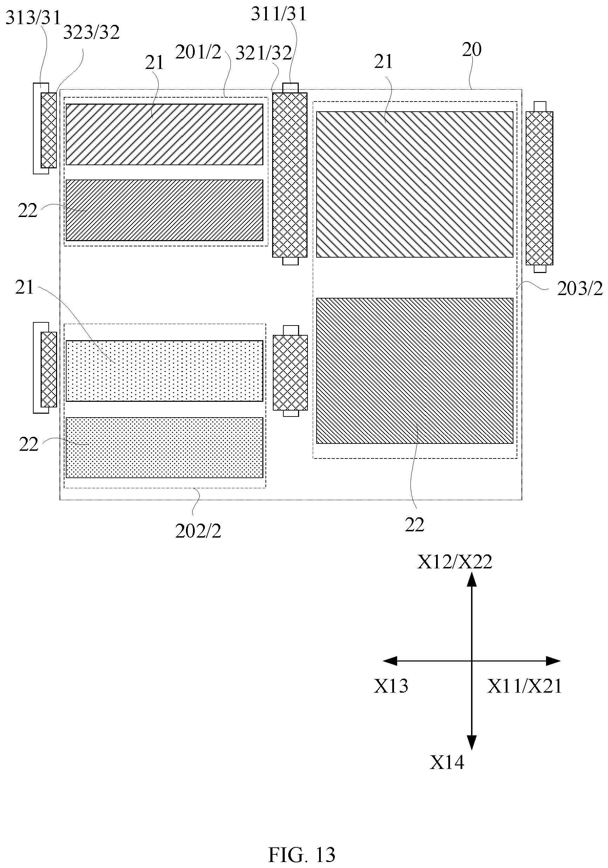

Besides the case where the first light-emitting unit 21 and the second light-emitting unit 22 in the same light-emitting element 2 are arranged along the first direction X21 as shown in FIG. 1 and FIG. 10, as shown in FIG. 13, in the same light-emitting element 2, the first light-emitting unit 21 and the second light-emitting unit 22 are arranged along the second direction X22, where FIG. 13 is an enlarged view of a light-emitting element group according to some embodiments of the present disclosure.

Based on this arrangement, the first light-blocking sub-portion 311 and the second light-blocking sub-portion 321 are located on a side of the first light-emitting unit 21 in the first direction X21, the lengths of the first light-blocking sub-portion and the second light-blocking sub-portion on two sides of the second light-emitting unit 22 in the first direction X21 can be shortened, and it is even possible to avoid arranging the first light-blocking sub-portion and the second light-blocking sub-portion on two sides of the second light-emitting unit 22 in the first direction X21 while meeting the privacy requirements of the display panel 100 in the first direction X21. As shown in FIG. 13, the first light-blocking sub-portion and the second light-blocking sub-portion may not be arranged on two sides of the second light-emitting unit 22 of the second-color light-emitting sub-element 202 in the first direction X21. In the sharing mode, more large-angle light emitted by the second light-emitting unit 22 towards the first direction X21 may exit without being blocked by the first light-blocking sub-portion and the second light-blocking sub-portion, which is beneficial to improving the sharing effect of the display panel in the first direction X21.

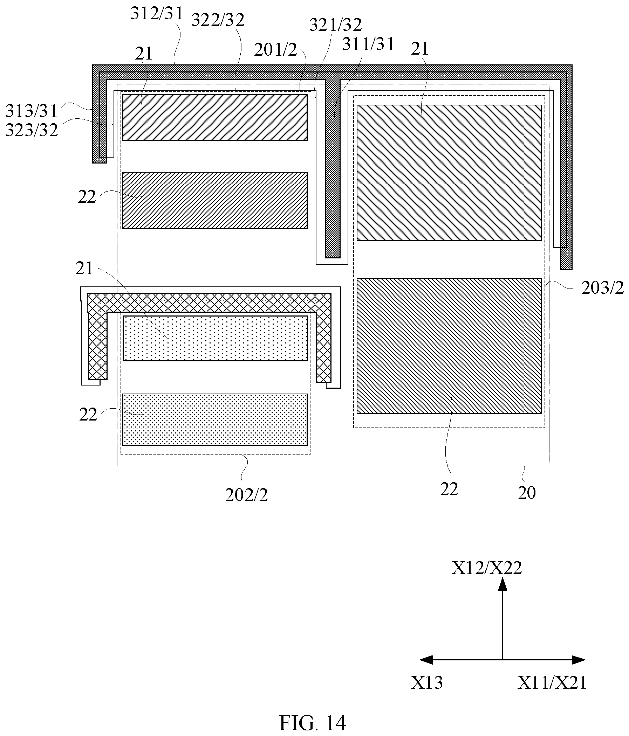

FIG. 13 takes the case where the display panel has a privacy effect in the first preset direction X11 and the third preset direction X13 for illustration. Alternatively, as shown in FIG. 14, when the first light-emitting unit 21 and the second light-emitting unit 22 in the same light-emitting element 2 are arranged along the second direction X22 , the above-described third light-blocking sub-portion 312 and fourth light-blocking sub-portion 322 may also be located on a side of the first light-emitting unit 21 in the second direction X22, so that the display panel has a privacy effect in the second direction X22, where FIG. 14 is an enlarged view of another light-emitting element group according to some embodiments of the present disclosure.

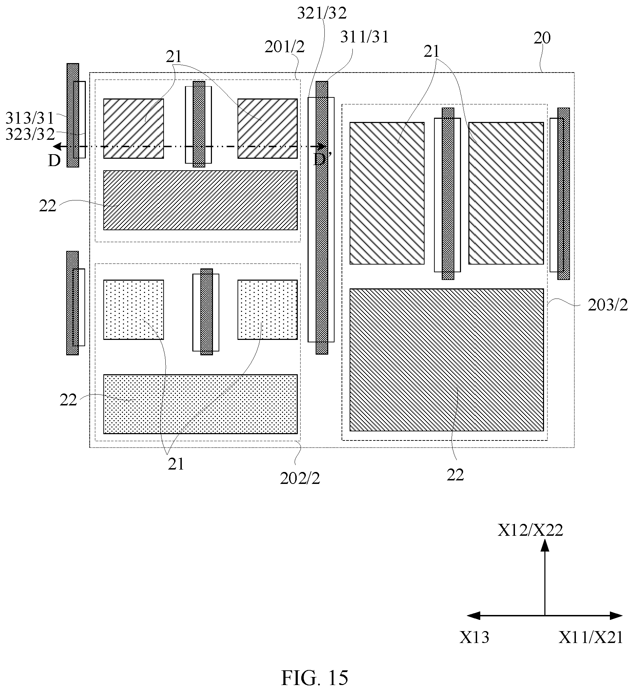

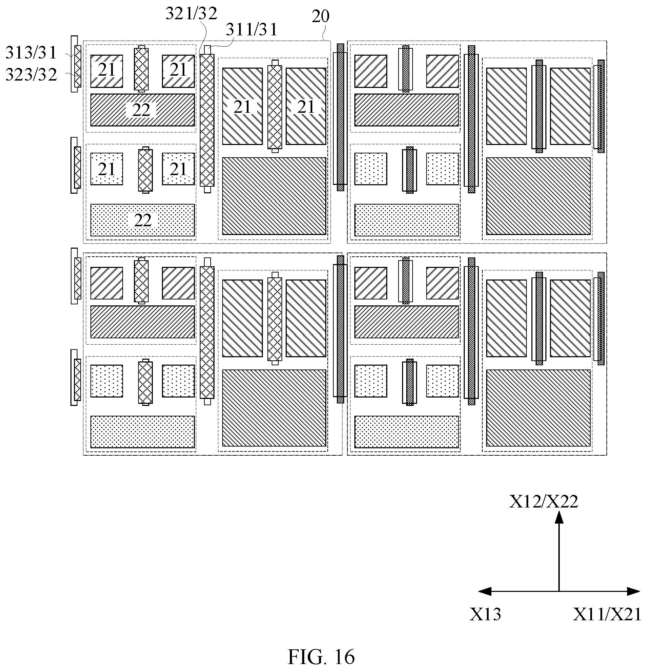

FIG. 15 is an enlarged view of another light-emitting element group according to some embodiments of the present disclosure, and FIG. 16 is an enlarged view of another display panel according to some embodiments of the present disclosure. For example, as shown in FIG. 15, the same light-emitting element 2 includes at least two first light-emitting units 21. Along the second direction X22, the second light-emitting unit 22 at least partially overlaps with at least two first light-emitting units 21 that belong to the same light-emitting element 2 as the second light-emitting unit 22. As shown in FIG. 16, light-emitting element groups 20 as shown in FIG. 15 are arranged in an array in the first direction X11 and the second direction X12.

In some embodiments of the present disclosure, the thicknesses of the first light-blocking layer 31 and the second light-blocking layer 32 are associated with the length of the first light-emitting unit 21 in the direction with privacy requirements. FIG. 15 takes the case where there are privacy requirements in the first preset direction X11 and the third preset direction X13, and the first preset direction X11 is parallel to the first direction X21 for illustration. The larger the length of the first light-emitting unit 21 in the first direction X11 is, the greater the thicknesses of the first light-blocking sub-portion 311 and the second light-blocking sub-portion 312 required for privacy may be, and the higher the requirements for the preparation process capabilities of the first light-blocking sub-portion 311 and the second light-blocking sub-portion 312 may be. In some embodiments of the present disclosure, by arranging at least two first light-emitting units 21 in the same light-emitting element 2 and configuring the second light-emitting unit 22 to at least partially overlap with the at least two first light-emitting units 21 that belong to the same light-emitting element 2 as the second light-emitting unit 22along the second direction X22, compared with the manner of only arranging one first light-emitting unit 21, the length of a single first light-emitting unit 21 in the first direction X11 can be reduced, thereby reducing the thicknesses of the first light-blocking sub-portion 311 and the second light-blocking sub-portion 312 required for privacy, and reducing the difficulty of the preparation process of the display panel.

For example, in some embodiments of the present disclosure, the area of the third opening 43 is smaller than or equal to the area of the fourth opening 44 to ensure that the display panel has a relatively large light-emitting area in the sharing mode, thereby guaranteeing the brightness in the sharing mode. Moreover, the thicknesses of the above-described first light-blocking layer 31 and second light-blocking layer 32 required for privacy can be reduced, and the difficulty of the preparation process of the display panel can be reduced.

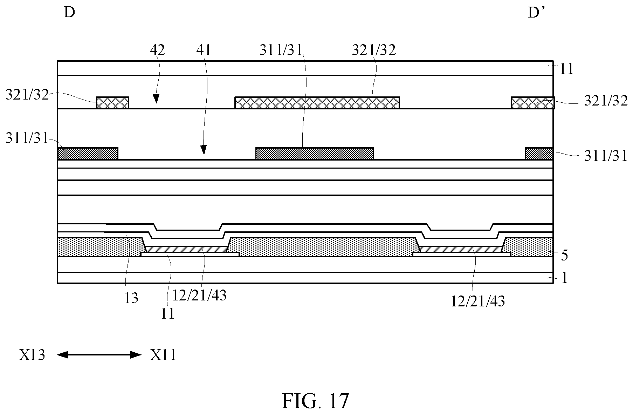

FIG. 17 is a cross-sectional view along the direction DD' in FIG. 15. In some embodiments, as shown in FIG. 17, the first light-emitting unit 21 includes a first electrode 11, a second electrode 12 and a light-emitting layer 13. For example, the first electrode 11 includes an anode, and the second electrode 12 includes a cathode. In some embodiments of the present disclosure, the first electrodes 11 of at least two adjacent first light-emitting units 21 are electrically connected to each other, so that the two first light-emitting units 21 can be turned on or turned off simultaneously, simplifying the circuit design of the display panel. For example, the first electrodes 11 of these two first light-emitting units 21 may be connected to the same pixel driving circuit.

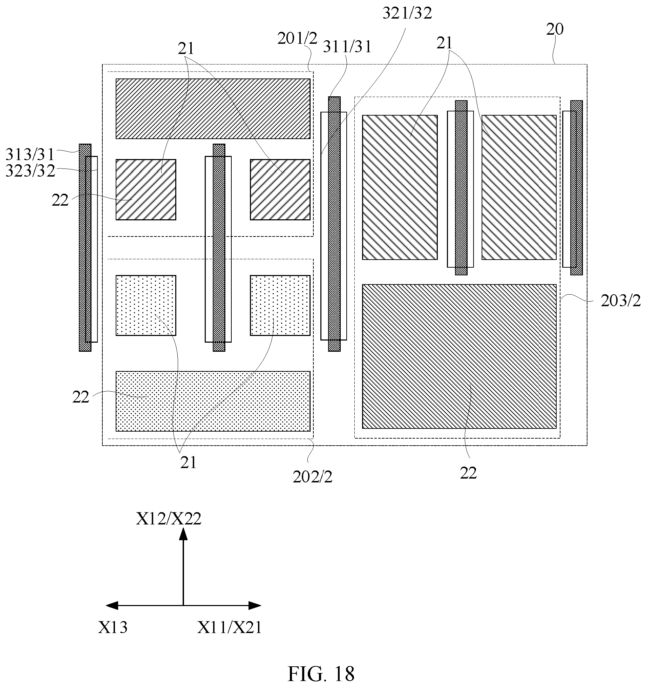

FIG. 18 is an enlarged view of another light-emitting element group according to some embodiments of the present disclosure. For example, as shown in FIG. 18, the first light-emitting unit 21 of the first-color light-emitting sub-element 201 is located on the side of the second light-emitting unit 22 of the first-color light-emitting sub-element 201 close to the first light-emitting unit 21 of the second-color light-emitting sub-element 202. The first light-emitting unit 21 of the second-color light-emitting sub-element 202 is located on the side of the second light-emitting unit 22 of the second-color light-emitting sub-element 202 close to the first light-emitting unit 21 of the first-color light-emitting sub-element 201. Based on this arrangement, the first light-emitting unit 21 of the first-color light-emitting sub-element 201 and the first light-emitting unit 21 of the second-color light-emitting sub-element 202 can both be located between the second light-emitting unit 22 of the first-color light-emitting sub-element 201 and the second light-emitting unit 22 of the second-color light-emitting sub-element 202. FIG. 18 takes the case where there are privacy requirements in the first preset direction X11 and the third preset direction X13, and the first preset direction X11 is parallel to the first direction X21 for illustration. While arranging the above-described first light-blocking sub-portion 311 and second light-blocking sub-portion 321 to achieve a large-viewing-angle privacy in the first preset direction X11, by adopting the arrangement manner of the light-emitting units shown in FIG. 18, the lengths of the first light-blocking sub-portion 311 and the second light-blocking sub-portion 321 located on two sides of the second light-emitting unit 22 of the first-color light-emitting sub-element 201 in the first preset direction X11 can be reduced, thereby weakening the influence of the first light-blocking sub-portion 311 and the second light-blocking sub-portion 321 on the light emission of the second light-emitting unit 22 of the first-color light-emitting sub-element 201 and improving the display effect in the sharing mode. In addition, the lengths of the first light-blocking sub-portion 311 and the second light-blocking sub-portion 321 located on two sides of the second light-emitting unit 22 of the second-color light-emitting sub-element 202 in the first preset direction X11 can be reduced, thereby weakening the influence of the first light-blocking sub-portion 311 and the second light-blocking sub-portion 321 on the light emission of the second light-emitting unit 22 of the second-color light-emitting sub-element 202 and improving the display effect in the sharing mode.

As shown in FIG. 18, the first light-blocking layer and the second light-blocking layer may not be arranged on two sides of the first light-emitting unit 21 of the first-color light-emitting sub-element 201 in the first preset direction X11. The first light-blocking layer and the second light-blocking layer may not be arranged on two sides of the second light-emitting unit 22 of the second-color light-emitting sub-element 202 in the first preset direction X11.

As shown in FIG. 18, the first light-emitting unit 21 of the third-color light-emitting sub-element 203 and the first light-emitting unit 21 of the first-color light-emitting sub-element 201 at least partially overlap with each other in the first direction X21. Based on this arrangement, the first light-blocking layer 31 and the second light-blocking layer 32 located therebetween may be used to block the large-viewing-angle light rays emitted by both the first light-emitting unit 21 of the third-color light-emitting sub-element 203 and the first light-emitting unit 21 of the first-color light-emitting sub-element 201, which is beneficial to simplifying the structure of the display panel.

As shown in FIG. 18, the second light-emitting unit 22 of the third-color light-emitting sub-element 203 and the second light-emitting unit 22 of the second-color light-emitting sub-element 202 at least partially overlap with each other in the first direction X21. The first light-blocking layer and the second light-blocking layer are not arranged therebetween to ensure that light emission of the second light-emitting unit 22 of the third-color light-emitting sub-element 203 and the second light-emitting unit 22 of the second-color light-emitting sub-element 202 is not affected by the first light-blocking layer and the second light-blocking layer, improving the display effect in the sharing mode.

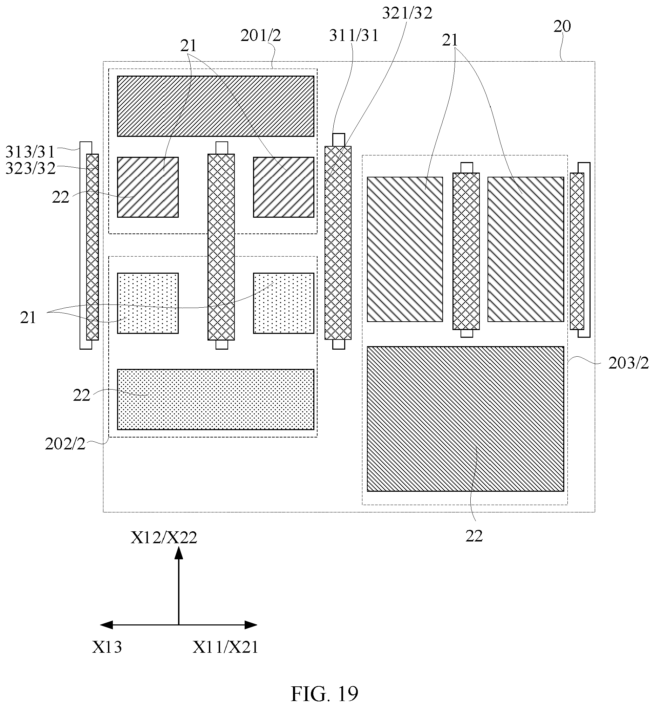

Besides at least partially overlapping with the first light-emitting unit 21 of the first-color light-emitting sub-element 201 in the first direction X21, the first light-emitting unit 21 of the third-color light-emitting sub-element 203 may also at least partially overlap with the first light-emitting unit 21 of the second-color light-emitting sub-element 202 in the first direction X21, for example, as shown in FIG. 19 which is an enlarged view of another light-emitting element group according to some embodiments of the present disclosure, such that the first light-blocking layer 31 and the second light-blocking layer 32 located therebetween may be used to block the large-viewing-angle light rays emitted by the first light-emitting unit 21 of the third-color light-emitting sub-element 203 and the first light-emitting unit 21 of the second-color light-emitting sub-element 202 simultaneously, which is beneficial to simplifying the structure of the display panel.

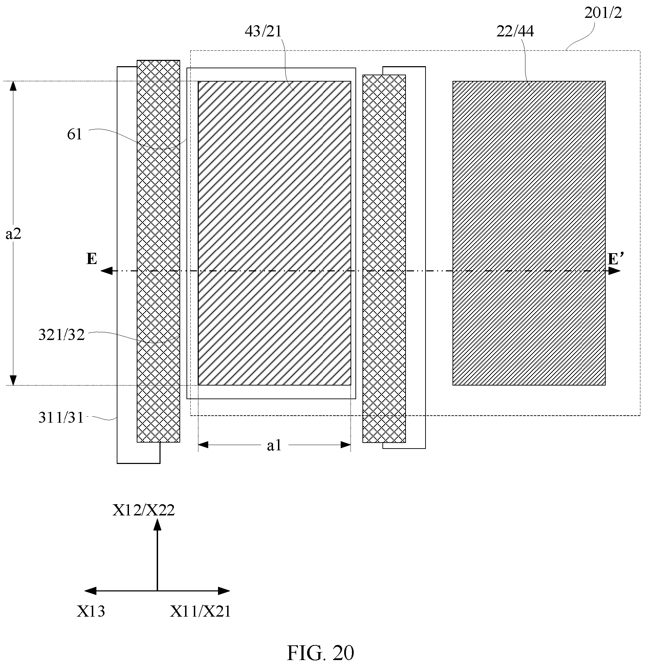

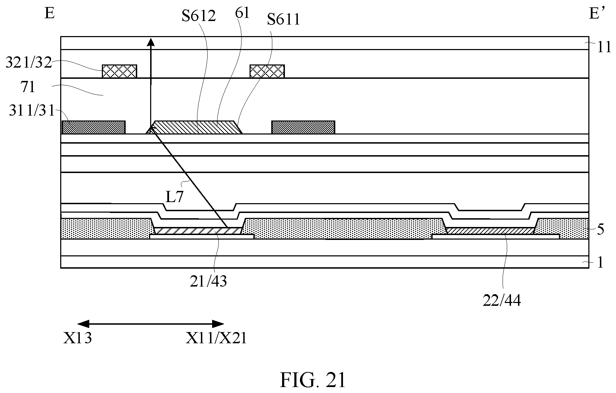

In some embodiments, as shown in FIG. 20 and FIG. 21, where FIG. 20 is an enlarged view of another light-emitting element according to some embodiments of the present disclosure, and FIG. 21 is a cross-sectional view along the direction EE' in FIG. 20, the display panel further includes a first light control portion 61. Along the direction perpendicular to the plane of the substrate 1, the first light control portion 61 at least partially overlaps with the first light-emitting unit 21. As shown in FIG. 21, an angle between the side surface S611 and the bottom surface S612 of the first light control portion 61 is an acute angle. The bottom surface of the first light control portion 61 is the surface of the first light control portion 61 on the side close to the substrate 1. The first light control portion 61 may adjust the large-angle light emitted by the first light-emitting unit 21 to be small-angle light for emission, such as the light ray L7 in FIG. 21. The arrangement of the first light control portion 61 can improve the brightness of the display panel at the front view, while reducing the light intensity of the large-angle light emitted by the first light-emitting unit 21 to achieve a large-viewing-angle privacy effect.

For example, as shown in FIG. 21, the display panel further includes a first protective layer 71 that at least partially covers the first light control portion 61. In some embodiments of the present disclosure, a refractive index of the first protective layer 71 is smaller than a refractive index of the first light control portion 61. For the large-angle light ray L7 emitted by the first light-emitting unit 21, when it is incident on the interface between the first light control portion 61 and the first protective layer 71, according to the law of refraction, the light ray will be deflected and exit the display panel as a small-angle light, so that the light intensity of the large-angle light emitted by the first light-emitting unit 21 can be reduced, and the brightness of the display panel at the front view can be improved.

For example, as shown in FIG. 20 and FIG. 21, in some embodiments of the present disclosure, an orthographic projection of the first light control portion 61 on the plane of the substrate 1 may at least partially cover an orthographic projection of the first light-emitting unit 21 on the plane of the substrate 1. In some embodiments, the shape of the orthographic projection of the first light control portion 61 on the plane of the substrate 1 may be the same as the shape of the orthographic projection of the first light-emitting unit 21 on the plane of the substrate 1.

When the display panel has privacy requirements in the first direction X11 , a length a2 of the first light-emitting unit 21 in the second direction X22 may be greater than a length a1 thereof in the first direction X21. Based on this arrangement, when arranging the above-described first light control portion 61, the length of the first light control portion 61 in the second direction X22 may be greater than the length of the first light control portion 61 in the first direction X21, that is, the length of the part of the side surface S611 of the first light-dimming portion 61 extending in the second direction X22 is larger, so that the part of the side surface S611 extending in the second direction X22 can receive more large-angle light and these large-angle light are adjusted to be small-angle light to exit the display panel.

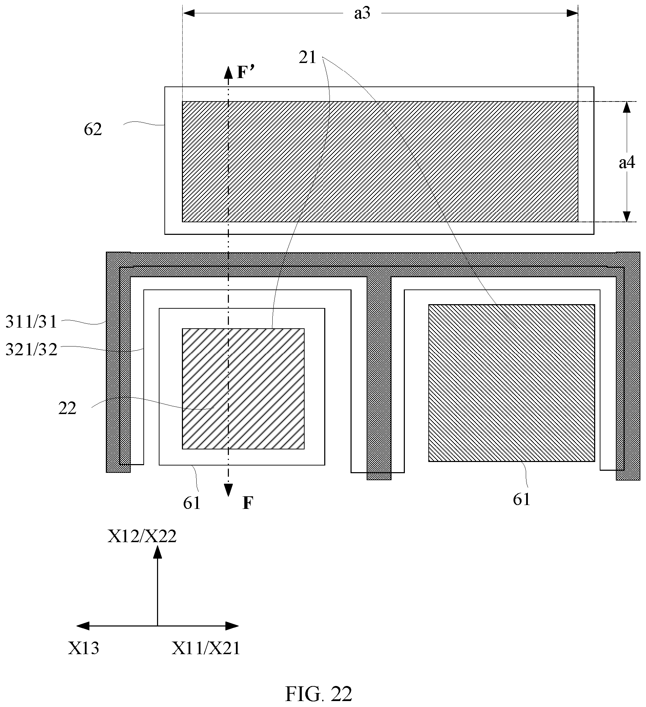

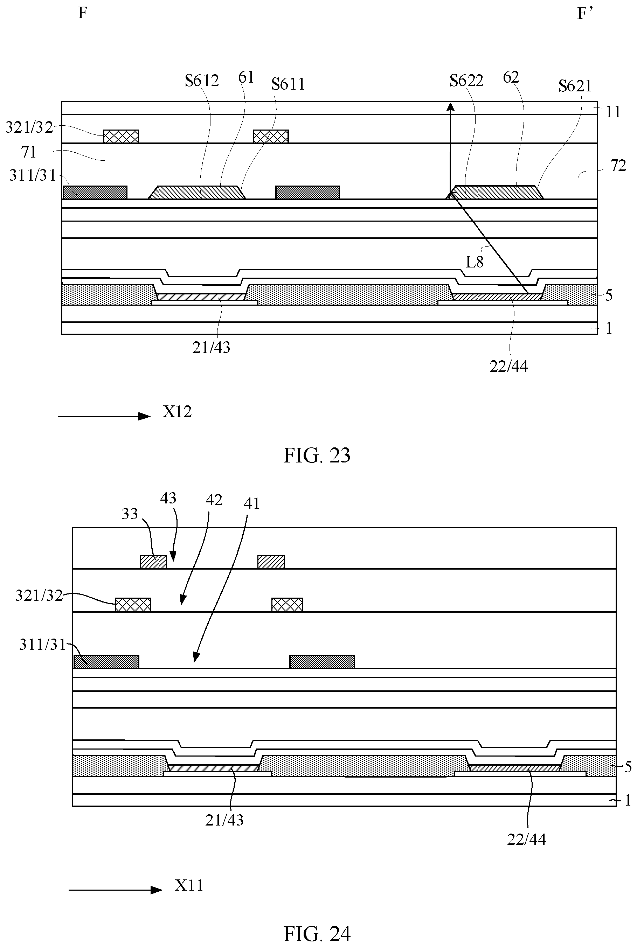

In some embodiments, as shown in FIG. 22 and FIG. 23, where FIG. 22 is an enlarged view of another light-emitting element according to some embodiments of the present disclosure, and FIG. 23 is a cross-sectional view along the direction FF' in FIG. 22, the display panel further includes a second light control portion 62. Along the direction perpendicular to the plane of the substrate 1, the second light control portion 62 at least partially overlaps with the second light-emitting unit 22. As shown in FIG. 23, an angle between the side surface S621 and the bottom surface S622 of the second light control portion 62 is an acute angle. The bottom surface of the second light control portion 62 is the surface of the second light control portion 62 on the side close to the substrate 1. The second light control portion 62 may adjust the large-angle light emitted by the second light-emitting unit 22 to be small-angle light for emission, such as the light ray L8 in FIG. 23.

For example, as shown in FIG. 23, the display panel further includes a second protective layer 72 that at least partially covers the second light control portion 62. A refractive index of the second protective layer 72 is smaller than a refractive index of the second light control portion 62. For the large-angle light ray L8 emitted by the second light-emitting unit 22, when it is incident on the interface between the second light control portion 62 and the second protective layer 72, according to the law of refraction, the light ray will be deflected and exit the display panel as a small-angle light, so that the light intensity of the large-angle light emitted by the second light-emitting unit 22 can be reduced, and the brightness of the display panel at the front view can be improved.

For example, as shown in FIG. 22 and FIG. 23, in some embodiments of the present disclosure, an orthographic projection of the second light control portion 62 on the plane of the substrate 1 may at least partially cover an orthographic projection of the second light-emitting unit 22 on the plane of the substrate 1. In some embodiments, the shape of the orthographic projection of the second light control portion 62 on the plane of the substrate 1 may be the same as the shape of the orthographic projection of the second light-emitting unit 22 on the plane of the substrate 1.

When the display panel is applied to a vehicle-mounted display screen, the above-described first direction X21 may be the direction between the driver's seat and the passenger's seat in a vehicle, and the second direction X22 may be the direction between the vehicle-mounted display screen and the windshield. In this scenario, by arranging the second light control portion 62 corresponding to the second light-emitting unit 22 and configuring the length a3 of the second light-emitting unit 22 in the first direction X21 to be greater than or equal to the length a4 of the second light-emitting unit 22 in the second direction X22, the length of the second light control portion 62 in the second direction X22 may be greater than or equal to the length of the second light control portion 62 in the first direction X21, that is, the length of the part of the side surface S621 of the second light control portion 62 extending in the first direction X21 is larger, so that the part of the side surface S621 extending in the first direction X21 can receive more large-angle light and these large-angle light are adjusted to be small-angle light to exit the display panel. In other words, the second light control portion 62 may be used to reduce the intensity of the large-angle light emitted from the vehicle-mounted display screen towards the windshield to a large extent, which may prevent the reflected light of the windshield from affecting the driver of the vehicle, and is beneficial to improving driving safety.

In some embodiments, as shown in FIG. 24, which is a cross-sectional view of another display panel according to some embodiments of the present disclosure, the display panel further includes a third light-blocking layer 33. The third light-blocking layer 33 is located on the side of the second light-blocking layer 32 away from the substrate 1. The third light-blocking layer 33 includes a fifth opening 45. Along the direction perpendicular to the plane of the substrate 1, the fifth opening 45 at least partially overlaps with the first light-emitting unit 21. Moreover, the area of the first opening 41 is greater than the area of the fifth opening 45, the area of the second opening 42 is greater than the area of the fifth opening 45, and the orthographic projection of the third light-blocking layer 33 on the plane of the substrate 1 at least partially covers the edge of the first opening 41. The orthographic projection of the third light-blocking layer 33 on the plane of the substrate 1 at least partially covers the edge of the second opening 42.

In the privacy mode, the first light-emitting unit 21 is turned on. The small-angle light emitted by the first light-emitting unit 21 can exit the display panel through the first opening 41, the second opening 42 and the fifth opening 45 in sequence, so that viewers at a relatively small viewing angle, such as viewers at the front view, can view the display screen. The large-angle light emitted by the first light-emitting unit 21 can be blocked by the third light-blocking layer 33, the second light-blocking layer 32 or the first light-blocking layer 31 and cannot exit the display panel, thus achieving the large-viewing-angle privacy effect of the display panel.

In the sharing mode, the light ray emitted by the second light-emitting unit 22 can bypass the first light-blocking layer 31, the second light-blocking layer 32 and the third light-blocking layer 33 and exit, so that viewers at both the front view and large viewing angles can view the display screen, achieving the screen sharing effect.

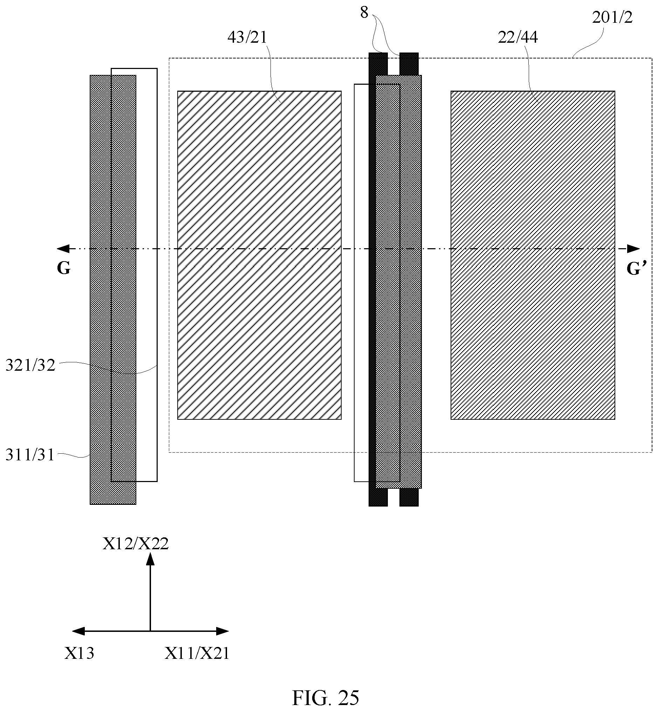

As shown in FIG. 25, which is an enlarged view of another light-emitting element according to some embodiments of the present disclosure, the display panel further includes a partition portion 8 located between the first light-emitting unit 21 and the second light-emitting unit 22. The arrangement of the partition portion 8 can reduce the lateral leakage current between the first light-emitting unit 21 and the second light-emitting unit 22, and avoid undesired turn-on of the first light-emitting unit 21 or the second light-emitting unit 22, which can improve the display effect in different display modes.

For example, in some embodiments of the present disclosure, the partition portion 8 overlaps with at least one of the above-described first light-blocking sub-portion 311 and the second light-blocking sub-portion 321, so as to make full use of the space between two adjacent light-emitting units, which is beneficial to improving the resolution of the display panel.

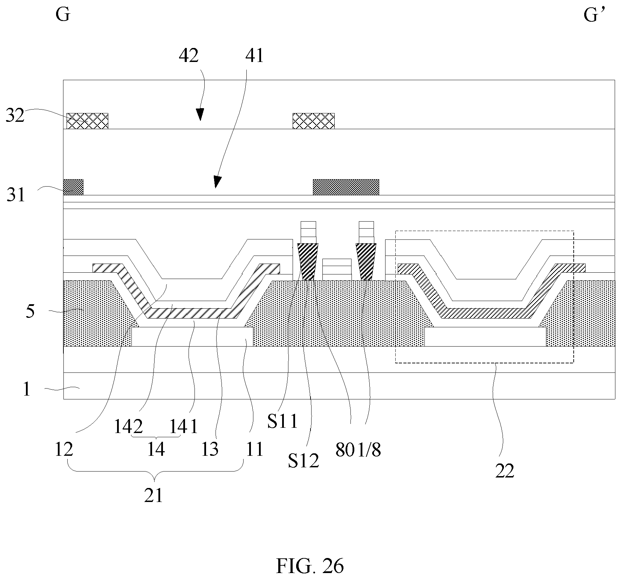

Combined with FIG. 26, which is a cross-sectional view along the direction GG' in FIG. 25, at least one of the first light-emitting unit 21 and the second light-emitting unit 22 includes a first electrode 11, a light-emitting layer 13, a second electrode 12 and a common layer 14. The partition portion 8 is located on the side of the common layer 14 close to the substrate 1. In some embodiments, the common layer 14 includes a first common sub-layer 141 and a second common sub-layer 142. The first common sub-layer 141 is located between the first electrode 11 and the light-emitting layer 13, and the second common sub-layer 142 is located between the second electrode 12 and the light-emitting layer 13. In some embodiments, the common layer 14 may by prepared with a common mask (Common Mask). The light-emitting layer 13 may be prepared with a fine metal mask (Fine Metal Mask, abbreviated as FMM).

In some embodiments of the present disclosure, the first electrode 11 of the first light-emitting unit 21 and the first electrode 11 of the second light-emitting unit 22 are independent of each other, and the second electrode 12 of the first light-emitting unit 21 may be electrically connected to the second electrode 12 of the second light-emitting unit 22.

In some embodiments, the first electrode 11 includes an anode, and the second electrode 12 includes a cathode. The first common sub-layer 141 includes a hole injection layer and/or a hole transport layer. The second common sub-layer 142 includes an electron injection layer and/or an electron transport layer.

As shown in FIG. 26, the partition portion 8 includes a protruding portion 801 that protrudes towards the side away from the substrate 1. In some embodiments, the protruding portion 801 includes a first side surface S11 and a first bottom surface S12 on the side close to the substrate 1. In some embodiments of the present disclosure, an angle between the first side surface S11 and the first bottom surface S12 and towards the inside of the protruding portion 801 may be set as an obtuse angle, that is, the area of the protruding portion 801 on the side away from the substrate 1 is greater than the area of the protruding portion 801 on the side close to the substrate 1. Based on this arrangement, the common layer 14 formed after the protruding portion 801 cannot be formed (or be continuously formed) at the first side surface S11 and thus is disconnected at the protruding portion 801, so that the path for the lateral leakage current to be transmitted between the adjacent first light-emitting unit 21 and second light-emitting unit 22 through the common layer 14 can be blocked, thereby suppressing the transmission of the lateral leakage current and improving the display effect. For example, in the privacy mode, undesired turn-on of the second light-emitting unit 22 due to transmission of the lateral leakage current to the second light-emitting unit 22 can be avoided.

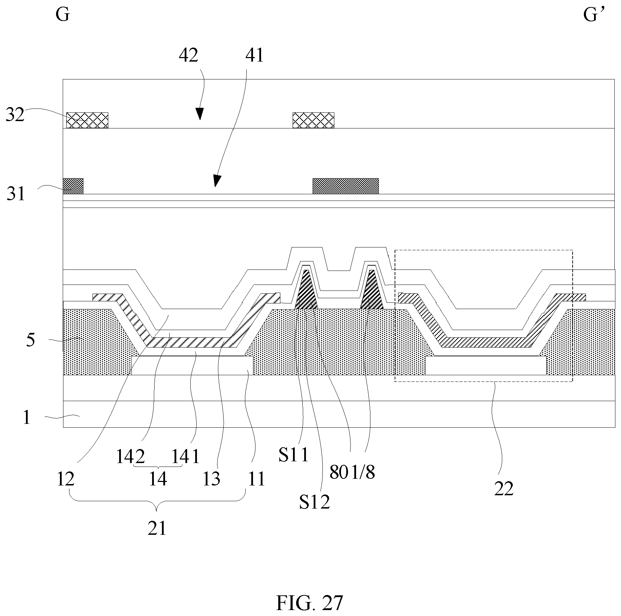

In some other embodiments, as shown in FIG. 27, which is another cross-sectional view along the direction GG' in FIG. 25, the angle between the first side surface S11 and the first bottom surface S12 and towards the inside of the protruding portion 801 may alternatively be set as an acute angle, that is, the area of the protruding portion 801 on the side away from the substrate 1 is smaller than the area of the protruding portion 801 on the side adjacent to the substrate 1. Based on this arrangement, the common layer 14 formed after the protruding portion 801 may be formed at the first side surface S11. Based on the morphological characteristics of the protruding portion 801, the path for the lateral leakage current to be transmitted between two adjacent sub-pixels through the common layer 14 can be extended, thereby suppressing the transmission of the lateral leakage current and improving the display effect.

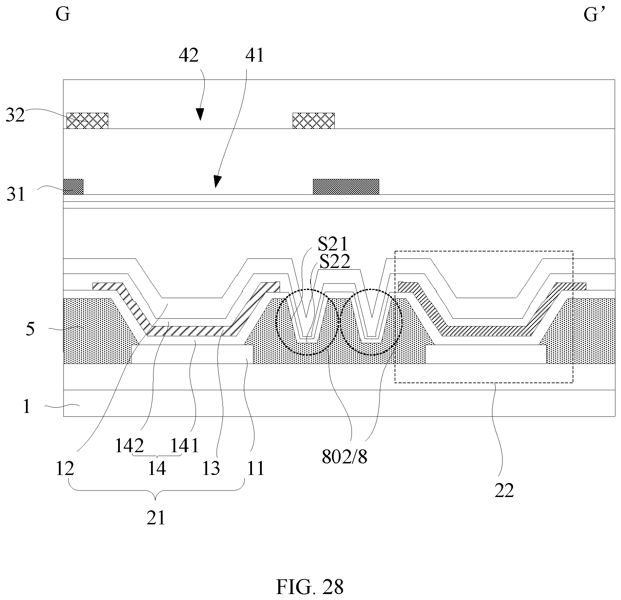

In some other embodiments, as shown in FIG. 28, which is another cross-sectional view along the direction GG' in FIG. 25, the partition portion 8 includes a recess portion 802 that is recessed towards the side of the substrate 1. The recess portion 802 includes a second side surface S21, and a second bottom surface S22 on the side close to the substrate 1. As shown in FIG. 28, an angle between the second side surface S21 and the second bottom surface S22 is an obtuse angle. Based on this arrangement, the common layer 14 formed after the recess portion 802 is formed at the second side surface S21 of the recess portion 802. Based on the morphological characteristics of the recess portion 802, the path for the lateral leakage current to be transmitted between two adjacent sub-pixels through the common layer 14 can be extended, thereby suppressing the transmission of the lateral leakage current and improving the display effect.

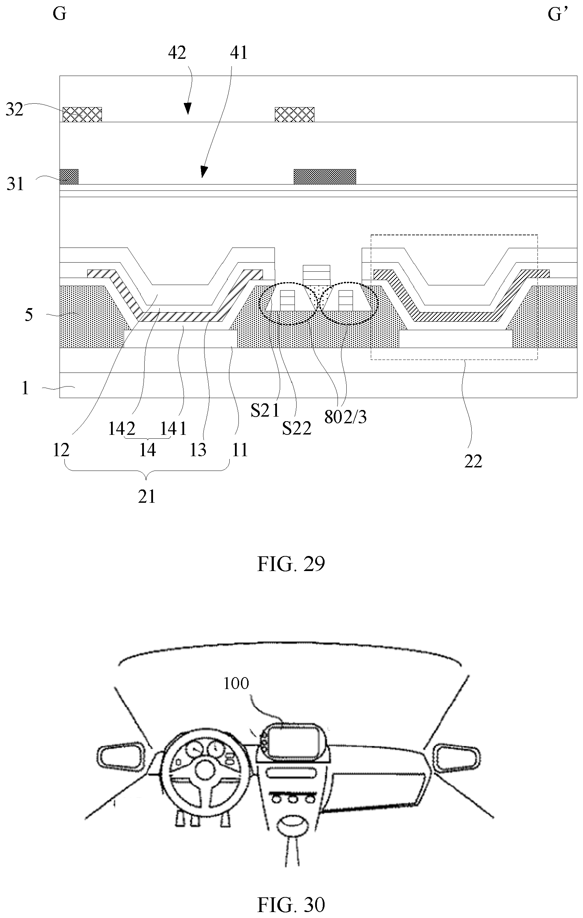

In some other embodiments, as shown in FIG. 29, which is another cross-sectional view along the direction GG' in FIG. 25, the angle between the second side surface S21 and the second bottom surface S22 may alternatively be set as an acute angle. Based on this arrangement, the common layer 14 formed after the recess portion 802 cannot be formed at the second side surface S21 and thus is disconnected at the recess portion 802, so that the path for the lateral leakage current to be transmitted between two adjacent sub-pixels through the common layer 14 may be blocked, thereby suppressing the transmission of the lateral leakage current and improving the display effect.

For example, as shown in FIG. 28 and FIG. 29, in some embodiments of the present disclosure, the recess portion 802 may be set in the above-described pixel definition layer 5.

Based on the same inventive concept, the embodiments of the present disclosure also provide a display apparatus. As shown in FIG. 30, which is a schematic diagram of a display apparatus according to some embodiments of the present disclosure, the display apparatus includes the above-described display panel 100. The structure of the display panel 100 has been described in detail in the above embodiments and will not be repeated here. It can be appreciated that the display apparatus shown in FIG. 30 is only for illustration. The display apparatus may be any device with a display function, such as a mobile phone, a tablet computer, a laptop computer, an e-book reader, a television, a smart watch, etc. When the display panel is applied in vehicles such as cars, ships or airplanes and used as a vehicle-mounted display screen, it may be independent of the inherent structure in the vehicles or a local structure integrated with other structural components in the vehicles. For example, the display panel may be integrated with the front windshield or integrated with the countertop around the instrument panel. The embodiments of the present disclosure impose no limitations on this aspect.

The above described is only some preferred embodiments of the present disclosure and is not intended to limit the present disclosure. Any modifications, equivalent replacements, improvements, etc. made within the spirit and principle of the present disclosure shall be included within the protection scope of the present disclosure.

## Claims

1. A display panel, comprising:
a substrate;
a plurality of light-emitting elements located on a side of the substrate, wherein the light-emitting element comprises a first light-emitting unit and a second light-emitting unit;
a first light-blocking layer located on a side of the first light-emitting unit away from the substrate and comprising a first opening; and
a second light-blocking layer located on a side of the first light-blocking layer away from the substrate and comprising a second opening;
wherein along a direction perpendicular to a plane of the substrate, both the first opening and the second opening at least partially overlap with the first light-emitting unit, and
an area of the first opening is greater than an area of the second opening, and an orthographic projection of the second light-blocking layer on the plane of the substrate at least partially covers an edge of the first opening.

2. The display panel according to claim 1, wherein operating modes of the display panel comprise a sharing mode and a privacy mode, and
in the sharing mode, the second light-emitting unit is turned on;
in the privacy mode, the first light-emitting unit is turned on and the second light-emitting unit is turned off.

3. The display panel according to claim 1,
wherein the first light-blocking layer comprises a first light-blocking sub-portion, and the second light-blocking layer comprises a second light-blocking sub-portion;
along a first preset direction parallel to the plane of the substrate, the first light-blocking sub-portion comprises a first edge close to the first light-emitting unit, and the second light-blocking sub-portion comprises a second edge close to the first light-emitting unit;
along the first preset direction, a shortest distance between the second edge and the first light-emitting unit is d3;
along the direction perpendicular to the plane of the substrate, a shortest distance between a surface of the second light-blocking sub-portion away from the substrate and a surface of the first light-emitting unit away from the substrate is h1; and
along the first preset direction, a length of the third opening is a1;
wherein d3 + a1 ≤ tan (arcsin (*n*2 × *sinθ*/*n*1)) × *h*1, θ is a maximum viewing angle in a privacy mode, n1 is a refractive index of the display panel, and n2 is a refractive index of air.

4. The display panel according to claim 3, wherein d3 ≥ 0.

5. The display panel according to claim 3, wherein
along the first preset direction, the second light-blocking sub-portion comprises a third edge away from the first light-emitting unit, and a shortest distance between the first edge and the third edge is d13;
along the first preset direction, the third opening comprises a first opening edge away from the first edge, and a maximum angle between a line connecting the first opening edge and the third edge and a normal of the substrate is α1; and
along the direction perpendicular to the plane of the substrate, a shortest distance between a surface of the first light-blocking sub-portion away from the substrate and the surface of the second light-blocking sub-portion away from the substrate is h12;
wherein d13 ≥ h12 × tanα1.

6. The display panel according to claim 1, further comprising:
a pixel definition layer comprising a third opening and a fourth opening, at least part of the first light-emitting unit being located within the third opening, and at least part of the second light-emitting unit being located within the fourth opening;
wherein the first light-blocking layer comprises a first light-blocking sub-portion, and the second light-blocking layer comprises a second light-blocking sub-portion;
the first light-emitting unit and the second light-emitting unit are arranged along a first preset direction;
along the first preset direction, a shortest distance between a third edge of the second light-blocking sub-portion and the second light-emitting unit is d2, and a shortest distance between the first light-blocking sub-portion and the fourth opening is d4; and
along the direction perpendicular to the plane of the substrate, a shortest distance between a surface of the second light-blocking sub-portion away from the substrate and a surface of the first light-emitting unit away from the substrate is h1, and a shortest distance between a surface of the second light-emitting unit away from the substrate and a surface of the first light-blocking sub-portion away from the substrate is h2;
wherein d4 ≥ d2 × h2/h1.

7. The display panel according to claim 6, wherein along the first preset direction, a width of the fourth opening is a2;
wherein a2 + a1 ≥ tan (arcsin (n2 × sinβ/n1)) × h1, β is a maximum viewing angle in a sharing mode, n1 is a refractive index of the display panel, and n2 is a refractive index of air.

8. The display panel according to claim 1,
wherein the first light-blocking layer comprises a third light-blocking sub-portion, and the second light-blocking layer comprises a fourth light-blocking sub-portion;
along a second preset direction parallel to the plane of the substrate, the fourth light-blocking sub-portion comprises a sixth edge close to the first light-emitting unit;
along the second preset direction, a shortest distance between the sixth edge and the first light-emitting unit is d6;
along the direction perpendicular to the plane of the substrate, a distance between a surface of the fourth light-blocking sub-portion away from the substrate and a surface of the first light-emitting unit away from the substrate is h3;
the display panel further comprises a pixel definition layer comprising a third opening and a fourth opening, at least part of the first light-emitting unit being located within the third opening, and at least part of the second light-emitting unit being located within the fourth opening; and
along the second preset direction, a length of the third opening is a2;
wherein d6 + a2 ≤ tan (arcsin (n2 × sinθ/n1)) × h3, θ is a maximum viewing angle in a privacy mode, n1 is a refractive index of the display panel, and n2 is a refractive index of air.

9. The display panel according to claim 8, wherein d6 ≥ 0.

10. The display panel according to claim 8, wherein
along the second preset direction, the third light-blocking sub-portion comprises a fifth edge close to the first light-emitting unit, and the fourth light-blocking sub-portion comprises a seventh edge away from the first light-emitting unit;
along the second preset direction, a shortest distance between the seventh edge and the fifth edge is d57;
along the second preset direction, the third opening comprises a second opening edge away from the fifth edge, and a maximum angle between a line connecting the second opening edge and the seventh edge and a normal of the substrate is α2; and
along the direction perpendicular to the plane of the substrate, a shortest distance between a surface of the third light-blocking sub-portion away from the substrate and the surface of the fourth light-blocking sub-portion away from the substrate is h34;
wherein d57 ≥ h34 × tanα2.

11. The display panel according to claim 1, comprising a plurality of light-emitting element groups,
wherein the light-emitting element group comprises a first-color light-emitting sub-element, a second-color light-emitting sub-element and a third-color light-emitting sub-element;
wherein in a same light-emitting element group, the third-color light-emitting sub-element and the first-color light-emitting sub-element are arranged along a first direction;
the third-color light-emitting sub-element and the second-color light-emitting sub-element are arranged along the first direction, the first-color light-emitting sub-element and the second-color light-emitting sub-element are arranged along a second direction, and the first direction intersects with the second direction; and
wherein at least one of the first-color light-emitting sub-element, the second-color light-emitting sub-element and the third-color light-emitting sub-element comprises the first light-emitting unit and the second light-emitting element.

12. The display panel according to claim 11, wherein in a same light-emitting element, the first light-emitting unit and the second light-emitting unit are arranged along the first direction.

13. The display panel according to claim 11, wherein in the same light-emitting element, the first light-emitting unit and the second light-emitting unit are arranged along the second direction.

14. The display panel according to claim 13, wherein a same light-emitting element comprises at least two first light-emitting units, and
along the second direction, the second light-emitting unit at least partially overlaps with at least two first light-emitting units that belong to the same light-emitting element with the second light-emitting unit.

15. The display panel according to claim 14, wherein the first light-emitting unit comprises a first electrode, and the first electrodes of at least two adjacent first light-emitting units are electrically connected to each other.

16. The display panel according to claim 11, wherein the first light-emitting unit of the first-color light-emitting sub-element is located on a side of the second light-emitting unit of the first-color light-emitting sub-element close to the first light-emitting unit of the second-color light-emitting sub-element,
the first light-emitting unit of the second-color light-emitting sub-element is located on a side of the second light-emitting unit of the second-color light-emitting sub-element close to the first light-emitting unit of the first-color light-emitting sub-element,
the first light-emitting unit of the third-color light-emitting sub-element and the first light-emitting unit of the first-color light-emitting sub-element at least partially overlap with each other in the first direction, and
the second light-emitting unit of the third-color light-emitting sub-element and the second light-emitting unit of the second-color light-emitting sub-element at least partially overlap with each other in the first direction.

17. The display panel according to claim 16, wherein the first light-emitting unit of the third-color light-emitting sub-element and the first light-emitting unit of the second-color light-emitting sub-element at least partially overlap with each other in the first direction.

18. The display panel according to claim 1, further comprising:
a pixel definition layer comprising a third opening and a fourth opening, wherein at least part of the first light-emitting unit being located within the third opening, and at least part of the second light-emitting unit being located within the fourth opening; and
wherein an area of the third opening is smaller than or equal to an area of the fourth opening.

19. The display panel according to claim 1, further comprising:
a first light control portion, wherein along the direction perpendicular to the plane of the substrate, the first light control portion at least partially overlaps with the first light-emitting unit, and an angle between a side surface and a bottom surface of the first light control portion is an acute angle.

20. The display panel according to claim 19, further comprising:
a first protective layer, wherein the first protective layer at least partially covers the first light control portion, and a refractive index of the first protective layer is smaller than a refractive index of the first light control portion.

21. The display panel according to claim 1, further comprising a second light control portion,
wherein along the direction perpendicular to the plane of the substrate, the second light control portion at least partially overlaps with the second light-emitting unit.

22. The display panel according to claim 21, further comprising a second protective layer,
wherein the second protective layer at least partially covers the second light control portion, and a refractive index of the second protective layer is smaller than a refractive index of the second light-dimming portion.

23. The display panel according to claim 22, wherein a length of the second light-emitting unit in the first direction is greater than or equal to a length of the second light-emitting unit in the second direction.

24. The display panel according to claim 1, further comprising:
a third light-blocking layer located on a side of the second light-blocking layer away from the substrate, the third light-blocking layer comprising a fifth opening;
wherein along the direction perpendicular to the plane of the substrate, the fifth opening at least partially overlaps with the first light-emitting unit, and an area of the first opening is greater than an area of the fifth opening, and an orthographic projection of the third light-blocking layer on the plane of the substrate at least partially covers the edge of the first opening.

25. The display panel according to claim 1, further comprising:
a partition portion located between the first light-emitting unit and the second light-emitting unit.

26. The display panel according to claim 25, wherein the partition portion comprises a recess portion or a protruding portion.

27. A display apparatus, comprising the display panel according to any one of claims 1 to 26.
